# EUROPEAN PATENT SPECIFICATION

(11) **EP 4 665 107 B1**
(45) Date of publication and mention of the grant of the patent: **19.08.2026**
(21) Application number: 25179640.5
(22) Date of filing: 29.05.2025
(51) Int. Cl.: H10B 12/00

(54) **SEMICONDUCTOR DEVICES HAVING INSULATING PATTERNS**
HALBLEITERANORDNUNGEN MIT ISOLIERENDEN MUSTERN
DISPOSITIFS SEMI-CONDUCTEURS À MOTIFS ISOLANTS

(30) Priority: 14.06.2024 KR 20240077469
(43) Date of publication of application: 17.12.2025
(73) Proprietor: Samsung Electronics Co., Ltd., Suwon-si, Gyeonggi-do 16677 (KR)
(72) Inventor: LEE, Hyunjin, 16677 Suwon-si (KR); CHAE, Heejae, 16677 Suwon-si (KR); KIM, Huijung, 16677 Suwon-si (KR); KIM, Yongkwan, 16677 Suwon-si (KR)
(74) Representative: Marks & Clerk LLP

(56) References cited:
- US-A1- 2023 320 077
- US-A1- 2023 363 143
- US-A1- 2024 147 706

## Description

### BACKGROUND

The present inventive concept relates to semiconductor devices having insulating structures.

As demand for high performance, high speed, and/or multi-functionality of semiconductor devices increases, the integration of semiconductor devices is increasing. In manufacturing semiconductor devices with fine patterns corresponding to the trend for high integration of semiconductor devices, it is important to implement patterns having fine widths or fine spacings.

### SUMMARY

A semiconductor device according to the invention is presented in claim 1. Embodiments of the invention are presented in the dependent claims.

Example embodiments provide a semiconductor device including insulating patterns disposed between a bitline structure and a back gate structure and between a bitline structure and a word line structure.

According to example embodiments, a semiconductor device includes a bitline structure; a back gate structure disposed on the bitline structure, and including a back gate electrode and a back gate dielectric layer covering a side surface and a lower surface of the back gate electrode; a word line structure disposed on the bitline structure and including a word line and a gate dielectric layer covering a side surface and a lower surface of the word line; an active pattern disposed on the bitline structure and extending in a vertical direction between the back gate structure and the word line structure; a first insulating pattern contacting the active pattern, between the bitline structure and the back gate structure; a second insulating pattern contacting the active pattern, between the bitline structure and the word line structure; and a contact pattern on the active pattern. A horizontal width of the first insulating pattern is smaller than a horizontal width of the back gate structure. A horizontal width of the second insulating pattern is smaller than a horizontal width of the word line structure. The active pattern may include a first portion between the back gate structure and the word line structure. The active pattern may include a second portion disposed below (e.g., vertically) the first portion. The second portion may be in contact with the first insulating pattern and the second insulating pattern. A horizontal width of the second portion may be greater than a horizontal width of the first portion.

According to example embodiments, a semiconductor device includes a bitline structure; back gate structures and word line structures disposed on the bitline structure and alternately disposed in a horizontal direction; active patterns disposed between the back gate structures and the word line structures, on the bitline structure, and extending in a vertical direction; first insulating patterns between the bitline structure and the back gate structures; second insulating patterns between the bitline structure and the word line structures; and contact patterns on the active patterns. Each of the active patterns may include a first portion between the back gate structure and the word line structure and a second portion disposed below the first portion and in contact with the first insulating pattern and the second insulating pattern. A horizontal width of the second portion may be greater than a horizontal width of the first portion. A horizontal width of each first insulating pattern is smaller than a horizontal width of each back gate structure. A horizontal width of each second insulating pattern is smaller than a horizontal width of each word line structure.

According to example embodiments, a semiconductor device includes a bitline structure; a back gate structure disposed on the bitline structure and including a back gate electrode and a back gate dielectric layer covering a side surface and a lower surface of the back gate electrode; a word line structure disposed on the bitline structure and including a word line and a gate dielectric layer covering a side surface and a lower surface of the word line; an active pattern disposed on the bitline structure and extending in a vertical direction between the back gate structure and the word line structure; a first insulating pattern contacting the active pattern, between the bitline structure and the back gate structure; a second insulating pattern contacting the active pattern, between the bitline structure and the word line structure; a contact pattern on the active pattern; and an information storage structure on the contact pattern. A horizontal width of the first insulating pattern is smaller than a horizontal width of the back gate structure. A horizontal width of the second insulating pattern is smaller than a horizontal width of the word line structure. The first insulating pattern vertically overlaps the back gate structure and extends in the vertical direction, and the second insulating pattern vertically overlaps the word line structure and extends in the vertical direction.

The described side surfaces may comprise a surface extending in a generally vertical direction. The described lower surface may comprise a surface extending in a generally horizontal direction. The horizontal direction may be perpendicular to the vertical direction. The described first insulating layer may be between the bitline structure and the back gate structure in a vertical direction. The described second insulating layer may be between the bitline structure and the word line structure in a vertical direction. The described horizontal widths may be width in a horizontal direction.

According to example embodiments, a method of manufacturing a semiconductor device may be provided. The semiconductor device may be any of the described semiconductor devices. The method may comprise forming first and second insulating patterns (e.g., the described insulating patterns) below a back gate trench and gate trench, respectively. The method may further comprise forming a bit line structure (e.g., the described bit line structure) to be in contact with the first and second insulating patterns. Forming the bit line structure may follow forming the patterns. The first and second insulating patterns may determine the distance at which a back gate electrode of the back gate structure (e.g., the described back gate electrode) and a word line of the word line structure (e.g., the described word line) are separated from the bit line structure. The process of etching back conductive material may be omitted. This may reduce vertical dispersion of the back gate electrode and/or the word line. This may improve performance of the semiconductor device, and/or reliability of manufacture.

At least some of the above and other features of the disclosure are set out in the claims.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a plan view of a semiconductor device according to an example embodiment;
FIG. 2 is a vertical cross-sectional view taken along line I-I' of the semiconductor device illustrated in FIG. 1;
FIG. 3 is an enlarged view of a portion of the semiconductor device illustrated in FIG. 2;
FIGS. 4 to 11 are cross-sectional views of semiconductor devices according to example embodiments;
FIGS. 12 to 25 are vertical cross-sectional views illustrating process steps of a method of manufacturing a semiconductor device according to an example embodiment; and
FIGS. 26 to 36 are vertical cross-sectional views illustrating process steps of a method of manufacturing a semiconductor device according to an example embodiment.

### DETAILED DESCRIPTION

Hereinafter, example embodiments will be described with reference to the accompanying drawings.

Items described in the singular herein may be provided in plural, as can be seen, for example, in the drawings. Thus, the description of a single item that is provided in plural should be understood to be applicable to the remaining plurality of items unless context indicates otherwise.

Terms such as "same," "equal," "planar," "coplanar," "parallel," and "perpendicular," as used herein encompass identicality or near identicality including variations that may occur resulting from conventional manufacturing processes. The term "substantially" may be used herein to emphasize this meaning, unless the context or other statements indicate otherwise.

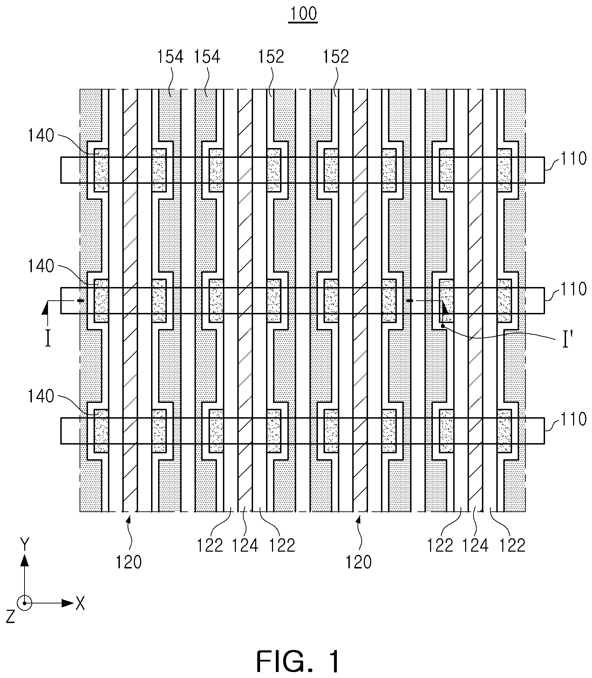

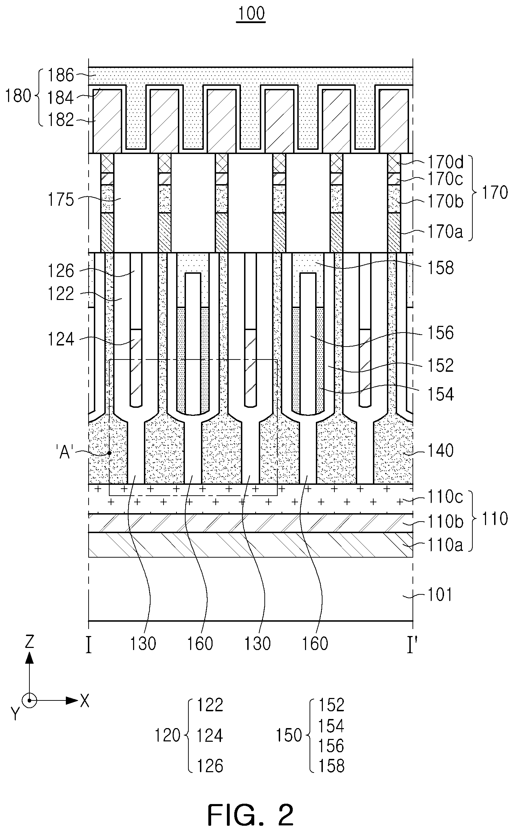

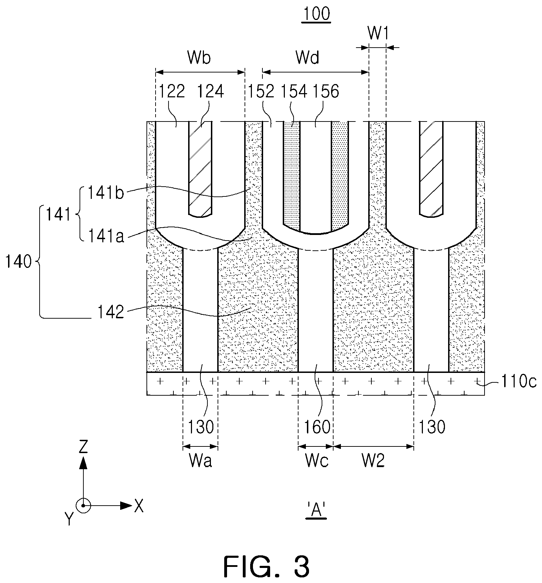

FIG. 1 is a plan view of a semiconductor device according to an example embodiment. FIG. 2 is a vertical cross-sectional view taken along line I-I' of the semiconductor device illustrated in FIG. 1. FIG. 3 is an enlarged view of a portion of the semiconductor device illustrated in FIG. 2. FIG. 3 may correspond to area A of FIG. 2.

Referring to FIGS. 1 to 3, a semiconductor device 100 according to an example embodiment may include a lower insulating layer 101, a bitline structure 110, a back gate structure 120, a word line structure 150, a contact pattern 170, and an information storage structure 180. The semiconductor device 100 may further include a first insulating pattern 130 and a second insulating pattern 160 disposed below the back gate structure 120 and the word line structure 150, respectively. In other words, the back gate structure 120 may overlay the first insulating pattern 130, and the word line structure 150 may overlay the second insulating pattern 160.

Spatially relative terms, such as "beneath," "below," "lower," "above," "upper," "top," "bottom," and the like, may be used herein for ease of description to describe one element's or feature's relationship to another element(s) or feature(s). It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

The semiconductor device 100 may include memory cells, each of which may include a vertical channel transistor. For example, each of the memory cells may include an active pattern 140, a bitline structure 110 electrically connected to the active pattern 140, and word lines 154 disposed on at least one side of the active pattern 140.

The semiconductor device 100 may be, for example, a semiconductor memory device including a cell array. For example, the semiconductor memory device may be a Dynamic Random Access Memory (DRAM), but the invention is not limited thereto. For example, the semiconductor device 100 may be a semiconductor chip including a die formed from a wafer. The die may include a substrate on which various subsequent layers are formed.

The lower insulating layer 101 may include an insulating material such as silicon oxide, silicon nitride, silicon oxynitride (SiON), or silicon carbonitride (SiCN).

The bitline structures 110 may be bitlines, which extend in the X-direction (e.g., horizontal) on the lower insulating layer 101. In an example embodiment, the bitline structure 110 may be embedded in the lower insulating layer 101. The bitline structure 110 may be electrically connected to the active pattern 140.

There may be a plurality of bitline structures 110, and the plurality of bitline structures 110 may extend in the X-direction parallel to each other and may be spaced apart from each other in the Y-direction.

The bitline structures 110 may include doped polysilicon, a metal, a conductive metal nitride, a metal-semiconductor compound, a conductive metal oxide, conductive graphene, carbon nanotubes, or combinations thereof. For example, at least one of the bitline structures 110 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotubes, or combinations thereof. In an example embodiment, the bitline structure 110 may include a first conductive pattern 110a, a second conductive pattern 110b, and a third conductive pattern 110c sequentially stacked on a lower insulating layer 101. The first conductive pattern 110a may include a metal material such as titanium (Ti), tantalum (Ta), tungsten (W), and aluminum (Al). The second conductive pattern 110b may include a metal nitride such as titanium nitride (TiN) or a silicide material such as titanium silicide (TiSi). The third conductive pattern 110c may include a semiconductor material such as polycrystalline silicon. The third conductive pattern 110c may be a layer doped with impurities (charge carrier dopants). However, depending on example embodiments, the material, the number of layers, and the thickness of the layers forming the bitline structure 110 may be variously changed.

The back gate structures 120 may be back gate patterns extending across the bitline structures 110. For example, the back gate structures 120 may extend in the Y-direction and may be spaced apart from each other in the X-direction.

The back gate structure 120 may include a back gate dielectric layer 122, a back gate electrode 124, and a back gate capping layer 126. The back gate electrodes 124 may extend in the Y-direction and may be spaced apart from each other in the X-direction. The back gate electrode 124 may serve to remove charges trapped in the active pattern 140. The active pattern 140 may be a floating body. The floating body is electrically separated from other components of the semiconductor device, and the floating body may be a portion of a transistor, which acts as source/drain and channel. The back gate electrode 124 may be a structure for supplementing the floating active pattern 140 to prevent or significantly reduce performance degradation of the semiconductor device 100 due to the floating body effect of the active pattern 140. The back gate electrode 124 may influence the transistor's operation to mitigate performance degradation caused by the floating body effect in the active pattern 140.

The back gate electrode 124 may include doped polysilicon, a metal, a conductive metal nitride, a metal-semiconductor compound, a conductive metal oxide, graphene, carbon nanotubes, or combinations thereof. For example, the back gate electrode 124 may be formed of, but is not limited to, doped polysilicon, Al, Cu, Ti, Ta, Ru, W, Mo, Pt, Ni, Co, TiN, TaN, WN, NbN, TiAl, TiAlN, TiAlC, TaAlC, TiSi, TiSiN, TaSi, TaSiN, RuTiN, NiSi, CoSi, IrOx, RuOx, graphene, carbon nanotubes, or combinations thereof. The back gate electrode 124 may be formed as a single layer or multiple layers of the materials described above.

The back gate dielectric layers 122 may extend in the Y-direction along both side surfaces (opposite side surfaces facing away from each other) of the back gate electrodes 124. The back gate dielectric layers 122 may cover both side surfaces and lower surfaces of the back gate electrodes 124. The vertical length of the back gate dielectric layer 122 may be greater than the vertical length of the back gate electrode 124. For example, the upper surface of the back gate dielectric layer 122 may be located at a level higher than the upper surface of the back gate electrode 124, and/or the lower end of the back gate dielectric layer 122 may be located at a level lower than the lower surface of the back gate electrode 124. In an example embodiment, the lower end of the back gate dielectric layer 122 may be spaced apart from the third conductive pattern 110c. The lower end of the back gate dielectric layer 122 may be spaced apart from the bitline structure (e.g., the third conductive pattern 110c) by the first insulating pattern 130. Each of the back gate dielectric layers 122 may include at least one of silicon oxide and a high-κ dielectric.

The back gate capping layer 126 may be disposed on the back gate electrode 124. The upper surface of the back gate capping layer 126 may be coplanar with the upper surface of the back gate dielectric layer 122. The back gate capping layer 126 may include silicon oxide, silicon nitride, silicon oxynitride, silicon carbonitride, a low-κ dielectric, or combinations thereof.

The first insulating pattern 130 may be disposed below the back gate structure 120. For example, the first insulating pattern 130 may be disposed between the back gate structure 120 and the bitline structure 110, and may extend in the vertical direction. The first insulating pattern 130 may extend in the Y-direction along the back gate structure 120. The upper surface of the first insulating pattern 130 may be in contact with the lower end of the back gate dielectric layer 122, and the lower surface of the first insulating pattern 130 may be in contact with the upper surface of the bitline structure 110, e.g., the third conductive pattern 110c. For example, the upper surface of the first insulating pattern 130 may be directly adjacent to or it is directly connected to the lower end of the back gate dielectric layer 122 The horizontal width (Wa) of the first insulating pattern 130 in the X-direction is smaller than the horizontal width (Wb) of the back gate structure 120 in the X-direction. For example, the horizontal width Wa in the X-direction may be the average width of the first insulating pattern 130 measured over the entire height level of the first insulating pattern 130, and the horizontal width Wb in the X-direction may be the greatest width of the back gate structure 120 measured over the entire height level of the back gate structure 120.

The first insulating pattern 130 may electrically and spatially isolate adjacent active patterns 140 from each other. The first insulating pattern 130 may include silicon oxide, silicon nitride, silicon oxynitride, silicon carbonitride, low-κ dielectric, or combinations thereof. In an example embodiment, the first insulating pattern 130 may include the same material as the back gate dielectric layer 122, and no interface may be observed between the first insulating pattern 130 and the back gate dielectric layer 122. In an example embodiment, the first insulating pattern 130 may include a different material from the back gate dielectric layer 122. The active patterns 140 may be described as being adjacent to each other with the understanding that the active patterns 140 are not in contact, i.e., directly adjacent, but rather separated by the first insulating pattern 130 or a second insulating pattern 160 as will be described. In other words, a first active pattern 140 may be adjacent a second active pattern 140 while being separated by a first insulating pattern 130 or a second insulating pattern 160.

When viewed in a cross-section, the back gate dielectric layer 122 may have a U-shape, and partially surround the back gate electrode 124. When viewed in a cross-section, the first insulating pattern 130 may have a rectangular shape (or I-shape), column shape, or pillar shape. The U-shaped back gate dielectric layer 122 may be connected to the top end of the first insulating pattern 130. When viewed in a cross-section, the first insulating pattern 130 may be connected to the bottom center of the U-shaped back gate dielectric layer 122.

The active pattern 140 may be disposed on the bitline structure 110 and may extend in the vertical direction (Z-direction). In the plan view, the active patterns 140 may be disposed on both sides (opposite sides facing away from each other) of the back gate structures 120. The active patterns 140 may be spaced apart from each other in the X-direction and the Y-direction. The upper surface of the active pattern 140 may be coplanar with the upper surface of the back gate structure 120. The lower surface of the active pattern 140 may be in contact with the third conductive pattern 110c and may be located at a lower level than the lower end of the back gate dielectric layer 122.

The active pattern 140 may include a first portion 141 and a second portion 142. The first portion 141 may be positioned between the back gate structure 120 and the word line structure 150, and the second portion 142 may be positioned between the first insulating pattern 130 and the second insulating pattern 160. For example, a portion of the active pattern 140 that is higher than the upper ends of the first insulating pattern 130 and the second insulating pattern 160 may be referred to as the first portion 141, and a portion of the active pattern 140 that is lower than the upper ends of the first insulating pattern 130 and the second insulating pattern 160 may be referred to as the second portion 142. The upper surface of the first portion 141 may be in contact with the contact pattern 170, and the lower surface of the second portion 142 may be in contact with the bitline structure 110.

The first portion 141 may extend vertically on the second portion 142. The first portion 141 may include a lower portion 141a and an upper portion 141b. The horizontal width of the lower portion 141a may decrease as it goes upward. In an example embodiment, the side surface of the lower portion 141a may be rounded. The upper portion 141b may extend vertically on the lower portion 141a. The first portion 141 may have a first width W1 in the X-direction, and the second portion 142 may have a second width W2 in the X-direction. The second width W2 may be greater than the first width W1. For example, the first width W1 in the X-direction may be the smallest width of the active pattern 140 measured over the entire height level of the first portion 141, and the second width W2 in the X-direction may be the average width of the active pattern 140 measured over the entire height level of the second portion 142. For example, the upper portion 141b may have the first width W1. The distance between the first portions 141 of the adjacent active patterns 140 may be greater than the distance between the second portions 142 of the adjacent active patterns 140. In this case, the distance between the first portions 141 of the adjacent active patterns 140 may be equal to the horizontal width (Wd) of the word line structure 150 in the X-direction, or the horizontal width (Wb) of the back gate structure 120 in the X-direction. For example, the horizontal width Wd in the X-direction may be the greatest width of the back gate structure 120 measured over the entire height level of the word line structure 150. The greatest distance in the X-direction between the first portions 141 of the adjacent active patterns 140 may be greater than the average distance in the X-direction between the second portions 142 of the adjacent active patterns 140. In this case, the greatest distance in the X-direction between the first portions 141 of the adjacent active patterns 140 may be equal to the horizontal width (Wd) of the word line structure 150 in the X-direction or the horizontal width (Wb) of the back gate structure 120 in the X-direction.

The distance between the second portions 142 of the adjacent active patterns 140 may be equal to the horizontal width (Wa) of the first insulating pattern 130 in the X-direction or the horizontal width (Wc) of the second insulating pattern 160 in the X-direction. For example, the average distance in the X-direction between the second portions 142 of the adjacent active patterns 140 may be equal to the horizontal width (Wa) of the first insulating pattern 130 in the X-direction or the horizontal width (Wc) of the second insulating pattern 160 in the X-direction.

Each of the active patterns 140 may include a first source/drain region in contact with the bitline structure 110, a second source/drain region connected to the contact pattern 170, and a channel region between the first source/drain region and the second source/drain region. In an example embodiment, the first and second source/drain regions may have an N-type conductivity type.

In an example embodiment, the active patterns 140 may include a single crystal semiconductor material. The single crystal semiconductor material may include a group IV semiconductor, a group III-V compound semiconductor, or a group II-VI compound semiconductor, and may be, for example, a single crystal semiconductor including at least one of silicon, silicon carbide, germanium, or silicon-germanium.

However, according to example embodiments, the active patterns 140 may include at least one of a polycrystalline semiconductor material layer, an oxide semiconductor material layer such as Indium Gallium Zinc Oxide (IGZO), or a two-dimensional material layer such as MoS₂ or the like.

The oxide semiconductor layer may be indium gallium zinc oxide (IGZO). However, the invention is not limited thereto. For example, the oxide semiconductor layer may include at least one of Indium Tungsten Oxide (IWO), Indium Tin Gallium Oxide (ITGO), Indium Aluminum Zinc Oxide (IAGO), Indium Gallium Oxide (IGO), Indium Tin Zinc Oxide (ITZO), zinc tin oxide (ZTO), indium zinc oxide (IZO), ZnO, indium gallium silicon oxide (IGSO), Indium Oxide (InO), Tin Oxide (SnO), Titanium Oxide (TiO), Zinc Oxynitride (ZnON), Magnesium Zinc Oxide (MgZnO), Indium Zinc Oxide (InZnO), Indium Gallium Zinc Oxide (InGaZnO), Zirconium Indium Zinc Oxide (ZrInZnO), Hafnium Indium Zinc Oxide (HflnZnO), Tin Indium Zinc Oxide (SnInZnO), Aluminum Tin Indium Zinc Oxide (AlSnInZnO), Silicon Indium Zinc Oxide (SiInZnO), Zinc Tin oxide (ZnSnO), aluminum zinc tin oxide (AlZnSnO), gallium zinc tin oxide (GaZnSnO), zirconium zinc tin oxide (ZrZnSnO), and indium gallium silicon oxide (InGaSiO).

The two-dimensional material layer may include at least one of a Transition Metal Dichalcogenide material layer (TMD material layer), a black phosphorous material layer, and a hexagonal Boron-Nitride material layer (hBN material layer) that may have semiconductor properties. For example, the two-dimensional material layer may include at least one of BiOSe, Crl, WSe2, MoS₂, TaS, WS, SnSe, ReS, β-SnTe, MnO, AsS, P(black), InSe, h-BN, GaSe, GaN, SrTiO, MXene, and Janus 2D materials, which may form a two-dimensional material.

The word line structures 150 may be word line patterns, which extend across the bitline structures 110. For example, the word line structures 150 may extend in the Y-direction and may be spaced apart from each other in the X-direction. The word line structures 150 may be alternately disposed in the X-direction with the back gate structures 120.

The word line structure 150 may include a gate dielectric layer 152, a word line 154, a first gate capping layer 156, and a second gate capping layer 158. Two word lines 154 spaced apart from each other in the X-direction may be disposed in each of the word line structures 150; however, this is exemplary and the disclosure is not limited thereto. The word line structure 150 may comprise a single word line, or more than two word lines. The word lines 154 may be disposed on the bitline structure 110 and may be disposed on both sides of the back gate structures 120. The word lines 154 may be spaced apart from each other in the X-direction and the Y-direction. In a plan view, the word line 154 may surround at least a portion of the active patterns 140, and the active patterns 140 may be disposed between the back gate structures 120 and the word line 154.

The word line 154 may include doped polysilicon, a metal, a conductive metal nitride, a metal-semiconductor compound, a conductive metal oxide, conductive graphene, carbon nanotubes, or combinations thereof. For example, the word line 154 may be formed of, but is not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, graphene, carbon nanotubes, or combinations thereof. The word line 154 may include a single layer or multiple layers of the materials described above. In an example embodiment, the word line 154 may be formed of the same material as the back gate electrode 124, but the invention is not limited thereto and may include other materials.

As shown in FIG. 1, two word lines 154 are disposed on both sides of one back gate electrode 124, but the invention is not limited thereto. In an example embodiment, the back gate electrodes 124 may be omitted. In an example embodiment, the back gate structures 120 may be replaced with additional word line structures which have substantially the same configuration as (or similar configuration to) the word line structures 150. For example, when viewed in a plan view, the semiconductor device 100 may have a double gate structure in which word lines 154 are disposed on both sides of an active pattern 140.

The gate dielectric layer 152 may be disposed between the word lines 154 and the active patterns 140, and may have a U-shape in a cross-sectional view. For example, the gate dielectric layer 152 may be in contact with the side surfaces and the lower surfaces of the word lines 154.

In an example, each of the gate dielectric layers 152 may be a tunnel dielectric layer that does not include an information storage layer. For example, each of the gate dielectric layers 152 may include at least one of silicon oxide and a high-κ dielectric. The high-κ dielectric may include a metal oxide or a metal oxide nitride. For example, the high-κ dielectric may be formed of, but is not limited to, HfO₂, HfSiO, HfSiON, HfTaO, HfTiO, HfZrO, ZrO₂, Al₂O₃, or combinations thereof. Each of the gate dielectric layers 152 may be formed of a single layer or multiple layers of the materials described above.

In another example, each of the gate dielectric layers 152 may include an information storage layer and a dielectric layer. For example, each of the gate dielectric layers 152 may include a ferroelectric layer that may have polarization characteristics depending on an electric field and may have remnant polarization due to a dipole even in the absence of an external electric field. Data may be recorded using the polarization state within the ferroelectric layer. Accordingly, each of the gate dielectric layers 152 may include a ferroelectric layer, which may be referred to as an information storage layer. The ferroelectric layer, which may be the information storage layer may include an Hf-based compound, a Zr-based compound, and/or a Hf-Zr-based compound. For example, the Hf-based compound may be an HfO-based ferroelectric material, the Zr-based compound may include a ZrO-based ferroelectric material, and the Hf-Zr-based compound may include a hafnium zirconium oxide (HZO)-based ferroelectric material. The ferroelectric layer, which may be the information storage layer may include a ferroelectric material doped with an impurity, for example, at least one of C, Si, Mg, Al, Y, N, Ge, and Sn, Gd, La, Sc, and Sr. For example, the ferroelectric layer, which may be the information storage layer, may be a material in which at least one of HfO2, ZrO2, and HZrO is doped with at least one of C, Si, Mg, Al, Y, N, Ge, Sn, Gd, La, Sc, and Sr.

In the gate dielectric layers 152, the information storage layer is not limited to the types of materials described above, and may include a material capable of storing information.

The gate capping layers 156 and 158 may extend in the Y-direction between adjacent word lines 154 and may be spaced apart from each other in the X-direction. The first gate capping layer 156 may be disposed between adjacent word lines 154 and may be in contact with facing side surfaces of the word lines 154. The second gate capping layer 158 may be disposed on the first gate capping layer 156 and may be in contact with the upper surfaces of the word lines 154 and the gate dielectric layer 152. The second gate capping layer 158 may be in contact with the upper surface and side surfaces of the first gate capping layer 156. The upper surface of the second gate capping layer 158 may be coplanar with the upper surface of the active pattern 140 and the upper surface of the back gate structure 120. In an example embodiment, the shape and arrangement structure of the first gate capping layer 156 and the second gate capping layer 158 may be different.

The first gate capping layer 156 and the second gate capping layer 158 may include silicon oxide, silicon nitride, silicon oxynitride, silicon carbonitride, a low-κ dielectric, or combinations thereof. For example, the first gate capping layer 156 may include silicon oxide, and the second gate capping layer 158 may include silicon nitride.

The second insulating pattern 160 may be disposed below the word line structure 150. For example, the second insulating pattern 160 may be disposed between the word line structure 150 and the bitline structure 110 (e.g., third conductive pattern 110c) and may extend in the vertical direction. The second insulating pattern 160 may extend in the Y-direction along the word line structure 150. An upper surface of the second insulating pattern 160 may be in contact with a lower end of the gate dielectric layer 152, and a lower surface of the second insulating pattern 160 may be in contact with an upper surface of the third conductive pattern 110c. A horizontal width (Wc) of the second insulating pattern 160 in the X-direction is smaller than a horizontal width (Wd) of the word line structure 150 in the X-direction. For example, the horizontal width Wc in the X-direction may be the smallest width of the second insulating pattern 160 measured over the entire height level of the second insulating pattern 160. In an example embodiment, the horizontal width (Wc) of the second insulating pattern 160 in the X-direction may be the same as the horizontal width (Wa) of the first insulating pattern 130 in the X-direction, but the invention is not limited thereto. In an example embodiment, the horizontal width (Wc) of the second insulating pattern 160 in the X-direction may be different from the horizontal width (Wa) of the first insulating pattern 130 in the X-direction.

The second insulating pattern 160 may electrically and spatially isolate adjacent active patterns 140 from each other. For example, the first insulating patterns 130 and the second insulating patterns 160 may be alternately disposed in the X-direction. The active patterns 140 may each include a side in contact with the first insulating pattern 130 and a side in contact with the second insulating pattern 160. For example, two opposite side surfaces of each of the second portion 142 of the active pattern 140 may be in contact with the first insulating pattern 130 and the second insulating pattern 160, respectively.

The distance between the first insulating pattern 130 and the second insulating pattern 160 may be greater than the distance between the back gate dielectric layer 122 and the gate dielectric layer 152. In this case, the distance between the first insulating pattern 130 and the second insulating pattern 160 may be equal to the second width W2 of the second portion 142 of the active pattern 140, and the distance between the back gate dielectric layer 122 and the gate dielectric layer 152 may be equal to the first width W1 of the first portion 141 of the active pattern 140. For example, the average distance in the X-direction between the first insulating pattern 130 and the second insulating pattern 160 may be greater than the shortest distance in the X-direction between the back gate dielectric layer 122 and the gate dielectric layer 152. For example, the average distance in the X-direction between the first insulating pattern 130 and the second insulating pattern 160 may be equal to the second width W2 of the second portion 142 of the active pattern 140, and the shortest distance in the X-direction between the back gate dielectric layer 122 and the gate dielectric layer 152 may be equal to the first width W1 of the first portion 141 of the active pattern 140.

The second insulating pattern 160 may include silicon oxide, silicon nitride, silicon oxynitride, silicon carbonitride, a low-κ dielectric, or combinations thereof. In an example embodiment, the second insulating pattern 160 may include the same material as the gate dielectric layer 152, and no interface may be observed between the second insulating pattern 160 and the gate dielectric layer 152. In an example embodiment, the second insulating pattern 160 may include a different material from the gate dielectric layer 152.

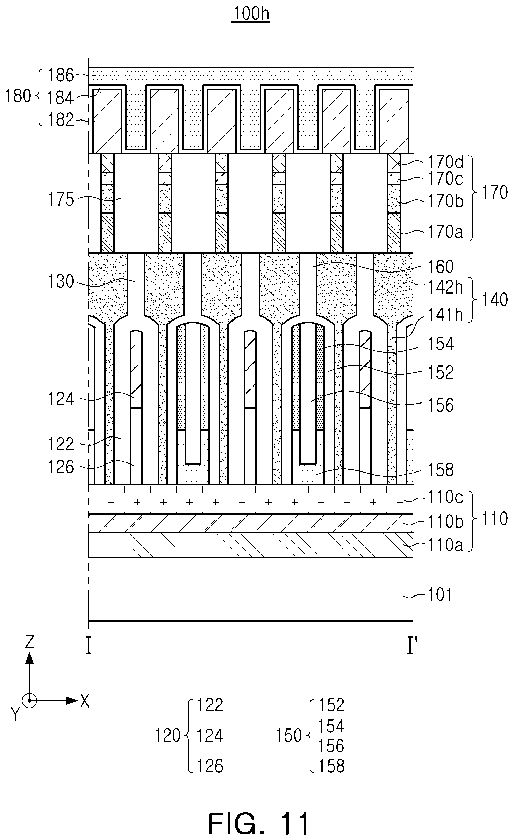

The first insulating pattern 130 may vertically overlap at least a portion of the back gate structure 120 and extend in the vertical direction, and the second insulating pattern 160 may vertically overlap at least a portion of the word line structure 150. For example, when viewed in a plan view (as viewed from the Z-direction) the first insulating pattern 130 may overlap at least a portion of the back gate structure 120, and the second insulating pattern 160 may overlap at least a portion of the word line structure 150. Such an arrangement is illustrated in FIG. 11. Alternatively, and as illustrated in FIG. 2, the back gate structure 120 may vertically overlap at least a portion of the first insulating pattern 130. The back gate structure 120 may extend in the vertical direction. The word line structure 150 may vertically overlap at least a portion of the second insulating pattern 160. The word line structure 150 may extend in the vertical direction.

The contact patterns 170 may be disposed on the active patterns 140 and may be electrically connected to the active patterns 140. The contact patterns 170 may electrically connect the active patterns 140 and the information storage structure 180.

The lower surfaces of the contact patterns 170 are illustrated as being in contact with the active pattern 140 and the gate dielectric layer 152, but according to other example embodiments, the lower surfaces of the contact patterns 170 may also be in contact with the back gate dielectric layer 122 and/or the back gate capping layer 126.

The contact patterns 170 may include a conductive material, such as doped single-crystalline silicon, doped polycrystalline silicon, a metal, a conductive metal nitride, a metal-semiconductor compound, a conductive metal oxide, conductive graphene, carbon nanotubes, or combinations thereof. In an example embodiment, the contact patterns 170 may include first to fourth contact layers (first to fourth contact patterns) 170a, 170b, 170c and 170d that are sequentially stacked. For example, the first contact layer 170a may include undoped polycrystalline silicon, the second contact layer 170b may include doped polycrystalline silicon, the third contact layer 170c may include a silicide material, and the fourth contact layer 170d may include a metal. However, depending on example embodiments, the configuration (e.g., the number of layers and the type of material) of the contact patterns 170 may be varied.

The semiconductor device 100 may further include insulating patterns 175 disposed between the contact patterns 170. The insulating patterns 175 may respectively extend vertically and may contact at least one of the back gate dielectric layer 122, the back gate capping layer 126, the gate dielectric layer 152, and the second gate capping layer 158. The insulating patterns 175 may spatially separate and electrically insulate the contact patterns 170.

The information storage structures 180 may be information storage patterns including first electrodes 182 electrically connected to the contact patterns 170, a second electrode 186 covering the first electrodes 182, and a dielectric layer 184 between the first electrodes 182 and the second electrode 186.

In an example embodiment, the information storage structures 180 may be capacitors that store information in a DRAM. For example, the dielectric layer 184 of the information storage structures 180 may be a capacitor dielectric layer of a DRAM, and the dielectric layer 184 may include a high-κ dielectric, silicon oxide, silicon nitride, silicon oxynitride, or combinations thereof.

According to example embodiments, the information storage structures 180 may be structures that store information of a memory other than a DRAM. For example, the dielectric layer 184 of the information storage structures 180 may be a capacitor dielectric layer of a ferroelectric memory (FeRAM). In this case, the dielectric layer 184 may be a ferroelectric layer that may record data using a polarization state. The ferroelectric layer may also, in another embodiment, include a lower dielectric layer including at least one of silicon oxide or a high-κ dielectric, and a ferroelectric layer disposed on the lower dielectric layer.

For example, the information storage structures 180 may be any kind of capacitor (e.g., a ferroelectric capacitor) used in a one-transistor one-capacitor (1T1C) memory cell, which is a type of memory comprising one capacitor and one transistor. For example, the information storage structures 180 may be any kind of resistor including an MTJ (magnetic tunnel junction), a ferroelectric tunnel junction (FTJ) and combinations thereof used in a one-transistor one-resistor (1T1R) memory cell, which is a type of memory comprising one resistor and one transistor. For example, the information storage structures 180 may be selected from the group consisting of data storage structures (or patterns) of a phase-change memory (PCM, PRAM, PCRAM, PC-RAM), a resistive memory (RRAM), a magnitoresistive memory (MRAM), a polymer memory (PRAM), a molecular memory, a ferroelectric memory (FeRAM), an ionic memory (PMC), a memristive memory, a spin memory, an oxide memory (such as ReRAM and 0xRAM), a conductive bridging random access memory (CBRAM), and combinations thereof.

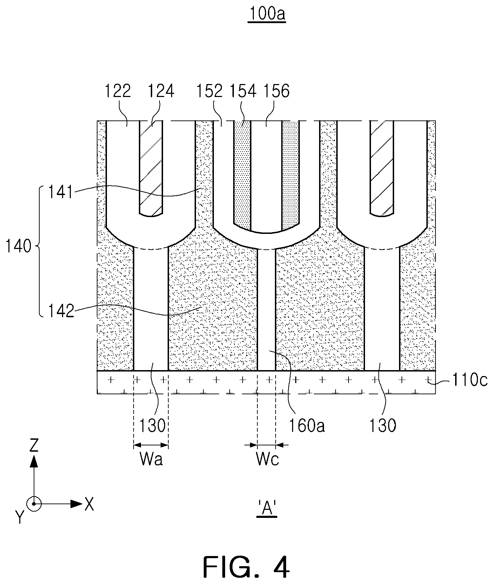

FIGS. 4 to 11 are cross-sectional views of semiconductor devices according to example embodiments. FIGS. 4 to 10 correspond to area A of FIG. 2, and FIG. 11 is a vertical cross-sectional view taken along line I-I' of the semiconductor device illustrated in FIG. 1.

Throughout the specification, like features and elements have been identified by the same or similar reference numerals and/or letters, and, repetitive descriptions may be omitted. In describing each embodiment, previously discussed content may be briefly explained or omitted for conciseness.

Referring to FIG. 4, a semiconductor device 100a may include a first insulating pattern 130 disposed below a back gate dielectric layer 122 and a second insulating pattern 160a disposed below a gate dielectric layer 152. In an example embodiment, a horizontal width (Wc) of the second insulating pattern 160a in the X-direction may be different from a horizontal width (Wa) of the first insulating pattern 130 in the X-direction. For example, the horizontal width (Wc) may be smaller than the horizontal width (Wa).

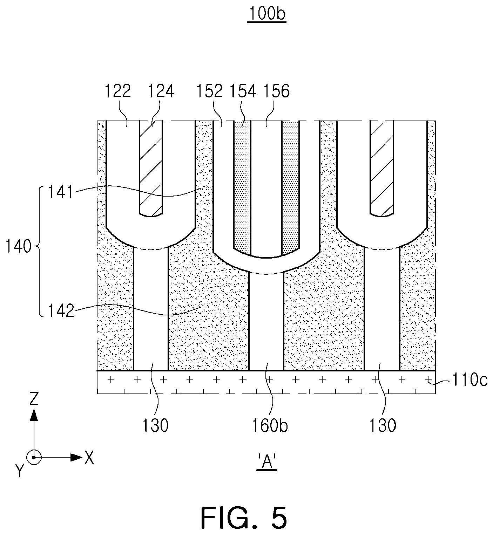

Referring to FIG. 5, a semiconductor device 100b may include a first insulating pattern 130 disposed below a back gate dielectric layer 122 and a second insulating pattern 160b disposed below a gate dielectric layer 152. In an example embodiment, the upper end of the second insulating pattern 160b may be disposed at a different level from the upper end of the first insulating pattern 130. For example, the upper end of the second insulating pattern 160b may be disposed at a lower level than the upper end of the first insulating pattern 130. Further, in an example embodiment, the lower end of the back gate structure 120 may be disposed at a different level from or than the lower end of the word line structure 150. For example, the lower end of the back gate structure 120 may be disposed at a higher level from or than the lower end of the word line structure 150.

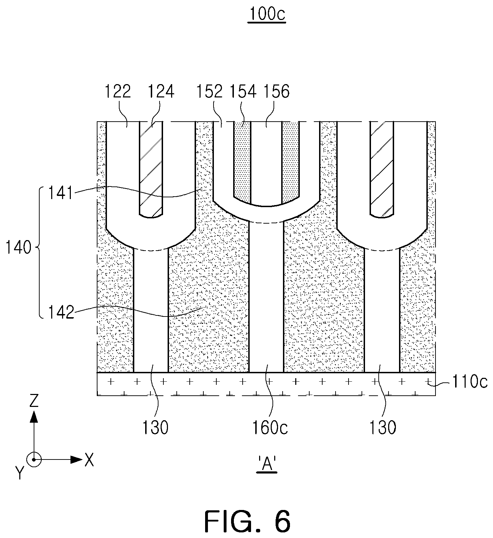

Referring to FIG. 6, a semiconductor device 100c may include a first insulating pattern 130 disposed below the back gate dielectric layer 122 and a second insulating pattern 160c disposed below the gate dielectric layer 152. In an example embodiment, the upper end of the second insulating pattern 160c may be disposed at a higher level than the upper end of the first insulating pattern 130. Further, in an example embodiment, the lower end of the back gate structure 120 may be disposed at a different level from or than the lower end of the word line structure 150. For example, the lower end of the back gate structure 120 may be disposed at a lower level from or than the lower end of the word line structure 150.

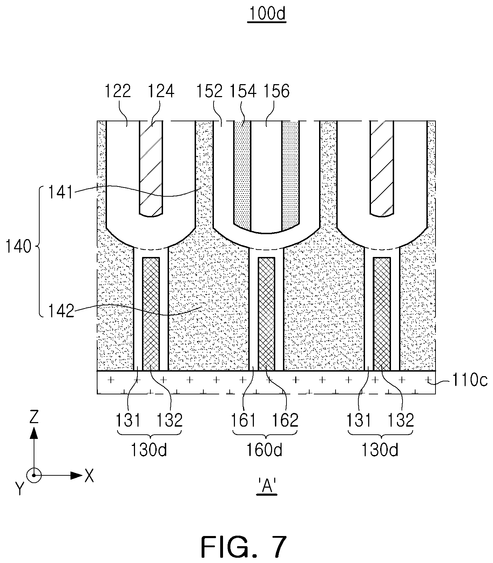

Referring to FIG. 7, a semiconductor device 100d may include a first insulating pattern 130d disposed below the back gate dielectric layer 122 and a second insulating pattern 160d disposed below the gate dielectric layer 152. In an example embodiment, the first insulating pattern 130d may include a first layer 131 and a second layer 132. The first layer 131 may cover side surfaces and an upper surface of the second layer 132 and may be in contact with the back gate dielectric layer 122. The lower surfaces of the first layer 131 and the second layer 132 may be coplanar and may be in contact with the bitline structure 110. The second layer 132 may be at least partially below the first layer 131, e.g., in the vertical (Z-axis) direction.

In an example embodiment, the second insulating pattern 160d may include a third layer 161 and a fourth layer 162. The third layer 161 may cover side surfaces and an upper surface of the fourth layer 162 and may be in contact with the gate dielectric layer 152. The lower surfaces of the third layer 161 and the fourth layer 162 may be coplanar and may be in contact with the bitline structure 110.

The first layer 131 and the second layer 132 of the first insulating pattern 130d and the third layer 161 and the fourth layer 162 of the second insulating pattern 160d may include silicon oxide, silicon nitride, silicon oxynitride, silicon carbonitride, a low-κ dielectric, or combinations thereof. In an example embodiment, the first layer 131 may include a different material from the second layer 132, and the third layer 161 may include a different material from the fourth layer 162. For example, the first layer 131 and the third layer 161 may include silicon oxide, and the second layer 132 and the fourth layer 162 may include silicon nitride.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

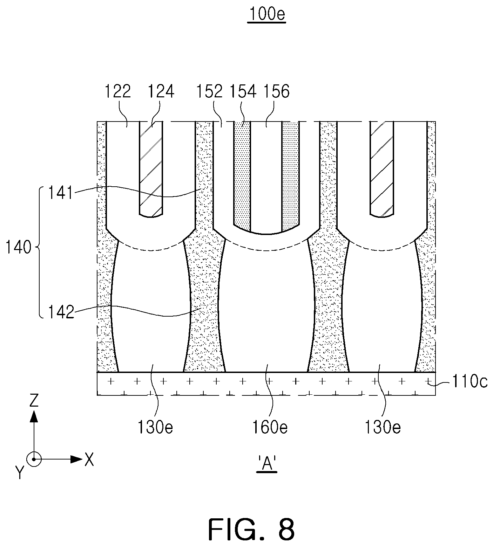

Referring to FIG. 8, a semiconductor device 100e may include a first insulating pattern 130e disposed under a back gate dielectric layer 122 and a second insulating pattern 160e disposed under a gate dielectric layer 152. In an example embodiment, at least one of the first insulating pattern 130e and the second insulating pattern 160e may have a convex side surface. The second portions 142 of the active patterns 140 may have a concave side surface.

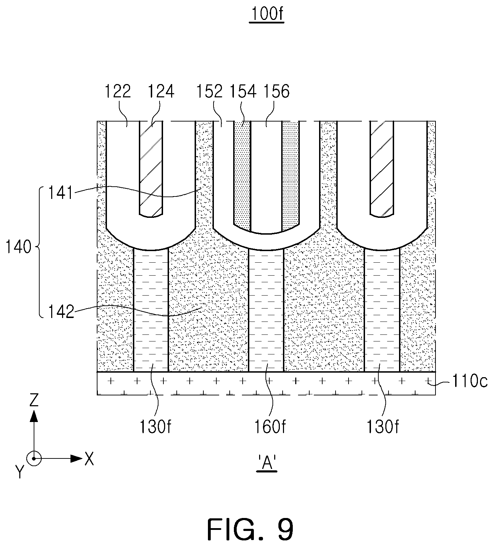

Referring to FIG. 9, a semiconductor device 100f may include a first insulating pattern 130f disposed under a back gate dielectric layer 122 and a second insulating pattern 160f disposed under a gate dielectric layer 152. In an example embodiment, the first insulating pattern 130f may include a different material from the back gate dielectric layer 122. In an example embodiment, the second insulating pattern 160f may include a different material from the gate dielectric layer 152.

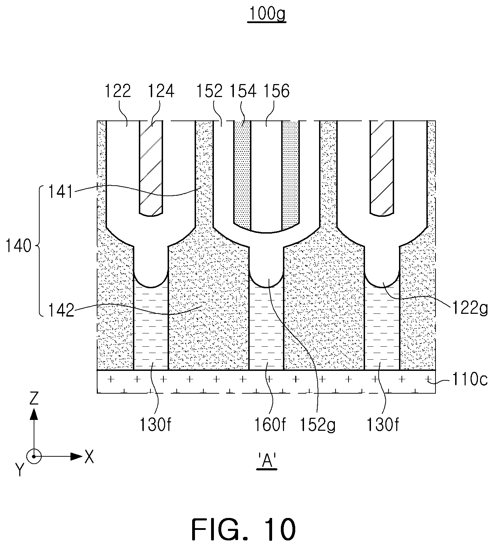

Referring to FIG. 10, a semiconductor device 100g may include a first insulating pattern 130f disposed below a back gate dielectric layer 122 and a second insulating pattern 160f disposed below a gate dielectric layer 152. The first insulating pattern 130f may include a different material from the back gate dielectric layer 122, and the second insulating pattern 160f may include a different material from the gate dielectric layer 152.

In an example embodiment, the back gate dielectric layer 122 may include a protrusion 122g protruding downward toward the first insulating pattern 130f. In an example embodiment, the gate dielectric layer 152 may include a protrusion 152g protruding downward toward the second insulating pattern 160f. The horizontal width of the protrusion 122g in the X-direction may be the same as the horizontal width (Wa) of the first insulating pattern 130f in the X-direction. The horizontal width of the protrusion 152g in the X-direction may be the same as the horizontal width (Wc) of the second insulating pattern 160f in the X-direction. For example, the horizontal greatest width of the protrusion 122g in the X-direction may be the same as the horizontal width (Wa) of the first insulating pattern 130f in the X-direction. The horizontal greatest width of the protrusion 152g in the X-direction may be the same as the horizontal width (Wc) of the second insulating pattern 160f in the X-direction. The lower surfaces of the protrusion 122g and the protrusion 152g are illustrated as being convex, but the invention is not limited thereto.

Referring to FIG. 11, a semiconductor device 100h may include a back gate structure 120, a first insulating pattern 130, and a word line structure 150 disposed between a bitline structure 110 and an information storage structure 180. In an example embodiment, the first insulating pattern 130 may be disposed between the back gate structure 120 and the information storage structure 180, and the second insulating pattern 160 may be disposed between the word line structure 150 and the information storage structure 180. The first insulating pattern 130 may overlay at least a portion of the back gate structure 120. The second insulating pattern 160 may overlay at least a portion of the word line structure 150. The lower surface of the back gate structure 120 and the lower surface of the word line structure 150 may be in contact with the upper surface of the bitline structure 110. The upper end of the back gate structure 120 and the upper end of the word line structure 150 may be spaced apart from the information storage structure 180.

The active pattern 140 may include a first portion 141h and a second portion 142h. The second portion 142h may have a horizontal width larger than that of the first portion 141h. For example, the average width in the X-direction measured over the entire height level of the second portion 142h may be greater than the smallest width in the X-direction measured over the entire height level of the first portion 141h. The first portion 141h may be disposed between the back gate structure 120 and the word line structure 150 and may extend in a vertical direction. The lower surface of the first portion 141h may be in contact with the bitline structure 110. The second portion 142h may be disposed on the first portion 141h and may be disposed between the first insulating pattern 130 and the second insulating pattern 160. The upper surface of the second portion 142h may be in contact with the contact pattern 170.

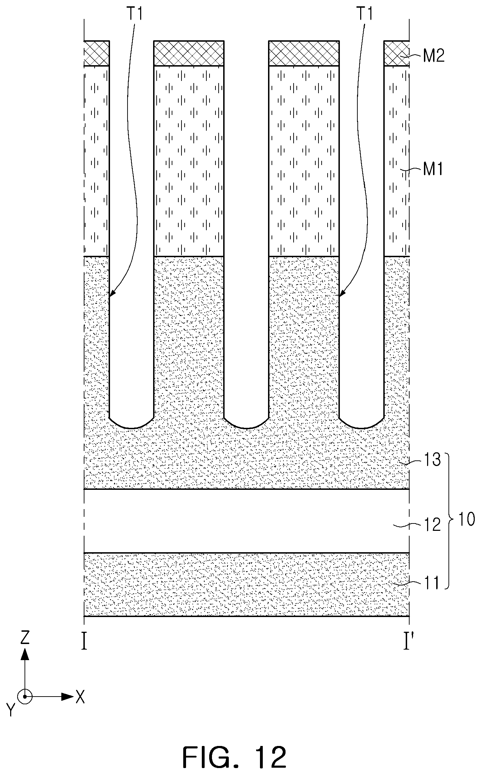

FIGS. 12 to 25 are vertical cross-sectional views illustrating a method of manufacturing a semiconductor device according to an example embodiment according to a process sequence. FIGS. 12 to 25 are vertical cross-sectional views taken along line I-I' of the semiconductor device illustrated in FIG. 1.

Referring to FIG. 12, a first mask layer M1 and a second mask layer M2 may be formed on a semiconductor substrate 10. In an example embodiment, the semiconductor substrate 10 may be a substrate in which an insulating layer is formed between semiconductor material layers, and may be, for example, a Silicon On Insulator (SOI) substrate. The semiconductor substrate 10 may include a lower semiconductor layer 11, an insulating layer 12, and an upper semiconductor layer 13. For example, the upper and lower semiconductor layers 11 and 13 may include single crystal silicon. In some embodiments, the semiconductor substrate 10 may be a bulk silicon substrate.

The first mask layer M1 and the second mask layer M2 may be used as hard masks in the etching process described below. The second mask layer M2 may include a material having an etching selectivity with respect to the first mask layer M1. In an example embodiment, the first mask layer M1 and the second mask layer M2 may include silicon oxide, silicon nitride, silicon oxynitride, silicon carbonitride, a low-κ dielectric, or combinations thereof. In an example embodiment, the first mask layer M1 and the second mask layer M2 may include polysilicon, a metal, a conductive metal nitride, or combinations thereof.

Back gate trenches T1 may be formed in the semiconductor substrate 10. The back gate trenches T1 may vertically penetrate the first mask layer M1, the second mask layer M2, and the upper semiconductor layer 13. The insulating layer 12 and the lower semiconductor layer 11 may not be exposed by the back gate trenches T1. The back gate trenches T1 may extend in the Y-direction and may be spaced apart from each other in the X-direction.

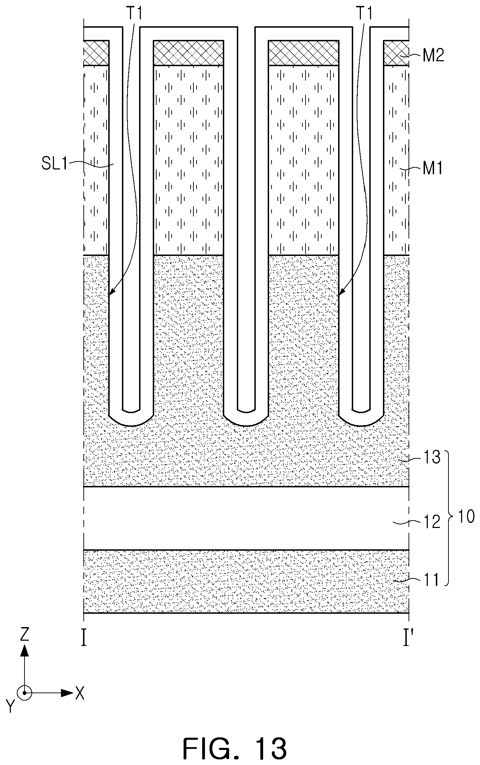

Referring to FIG. 13, a first sacrificial layer SL1 may be conformally formed along the inner walls of the back gate trenches T1. The first sacrificial layer SL1 may cover the inner walls of the first mask layer M1, the second mask layer M2, and the upper semiconductor layer 13 exposed by the back gate trenches T1 and may cover the upper surface of the second mask layer M2. The first sacrificial layer SL1 may include silicon oxide, silicon nitride, silicon oxynitride, silicon carbonitride, a low-κ dielectric, or combinations thereof. For example, the first sacrificial layer SL1 may include silicon oxide.

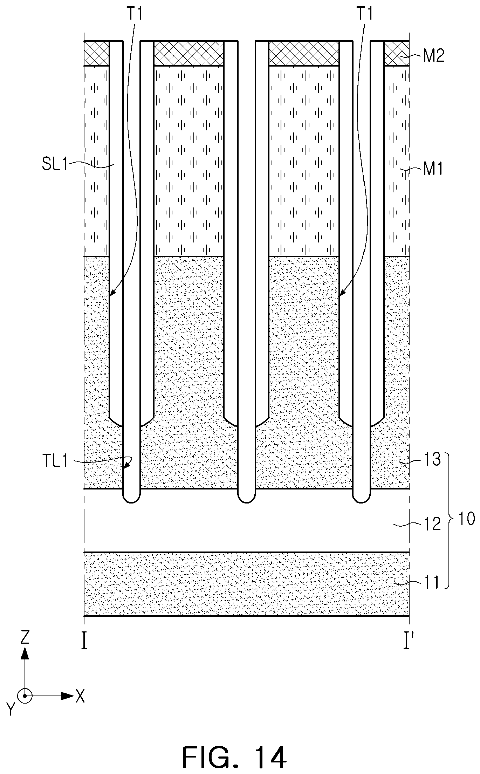

Referring to FIG. 14, an anisotropic etching process may be performed, and first lower trenches TL1 may be formed below the back gate trenches T1. The first lower trenches TL1 may expose inner walls of the upper semiconductor layer 13 and an upper surface of the insulating layer 12. The lower semiconductor layer 11 may not be exposed by the first lower trenches TL1. The first lower trenches TL1 may extend in the Y-direction along the back gate trenches T1 and may be spaced apart from each other in the X-direction. The horizontal width in the X-direction of the first lower trench TL1 may be smaller than the horizontal width in the X-direction of the back gate trench T1. For example, the horizontal average width in the X-direction of the first lower trench TL1 may be smaller than the horizontal average width in the X-direction of the back gate trench T1.

A portion of the first sacrificial layer SL1 covering the upper surface of the second mask layer M2 may be removed by the anisotropic etching process, and an upper portion of the second mask layer M2 may be partially etched. The first sacrificial layers SL1 may be disposed on the sidewalls of the first lower trenches TL1. For example, the first sacrificial layers SL1 may be exposed by the sidewalls of the first lower trenches TL1.

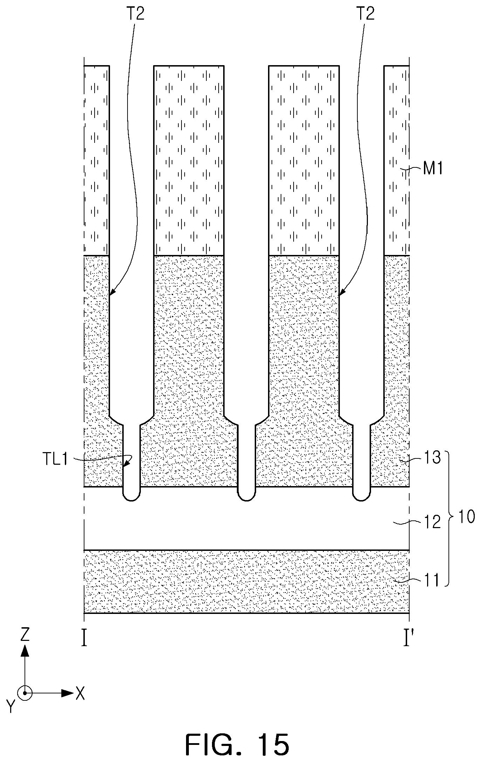

Referring to FIG. 15, the second mask layer M2 and the first sacrificial layers SL1 may be selectively removed. For example, the second mask layer M2 and the first sacrificial layers SL1 may be removed by the wet etching process, thereby exposing the inner walls of the first mask layer M1 and the upper semiconductor layer 13.

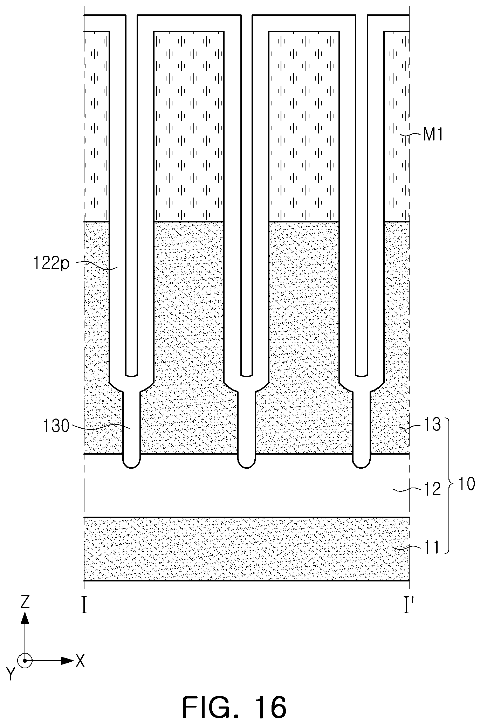

Referring to FIG. 16, a dielectric material layer 122p may be formed. For example, the dielectric material layer 122p may be deposited along the back gate trenches T1 and the first lower trenches TL1 by a chemical vapor deposition (CVD) method, an atomic layer deposition (ALD) method, or the like. The dielectric material layer 122p may cover an upper surface of the first mask layer M1 and may cover an inner wall of the back gate trenches T1. The dielectric material layer 122p may completely fill the first lower trenches TL1, and the dielectric material layer 122p disposed within the first lower trenches TL1 may be referred to as first insulating patterns 130. The lower end of the first insulating patterns 130 may be lower than the upper surface of the upper semiconductor layer 13 and may be in contact with the insulating layer 12.

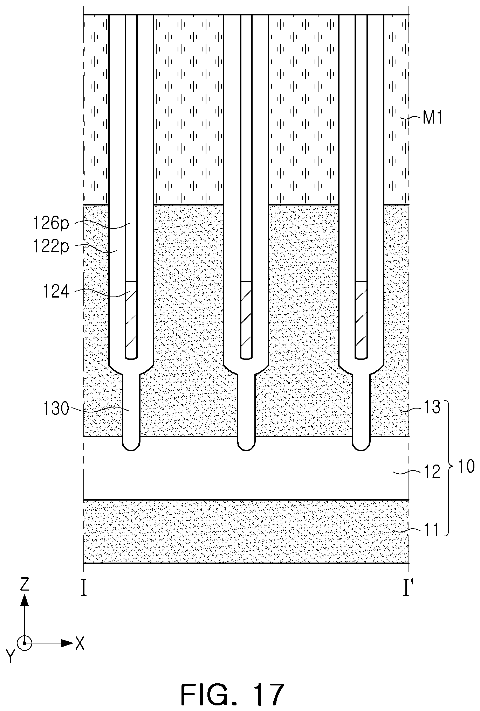

Referring to FIG. 17, a portion of the dielectric material layer 122p covering the upper surface of the first mask layer M1 may be removed, and back gate electrodes 124 and preliminary capping layers 126p may be formed on the dielectric material layer 122p. The back gate electrodes 124 may fill the lower portions of the back gate trenches T1, and the preliminary capping layers 126p may be disposed on the back gate electrodes 124. In an example embodiment, the back gate electrode 124 may include a metal nitride such as TiN or polycrystalline silicon.

The preliminary capping layer 126p may include a material having an etching selectivity with respect to the first mask layer M1. The preliminary capping layer 126p may include silicon oxide, silicon nitride, silicon oxynitride, or combinations thereof. In an example embodiment, the preliminary capping layer 126p may include silicon oxide.

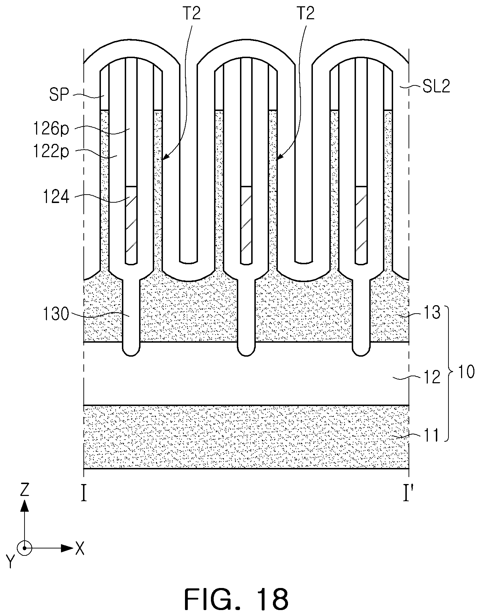

Referring to FIG. 18, the first mask layer M1 may be removed and the side surface of the dielectric material layer 122p may be exposed. For example, the first mask layer M1 may be selectively removed by a wet etching process. The dielectric material layers 122p and the preliminary capping layers 126p include materials having an etching selectivity with the first mask layer M1, and thus may not be etched.

After the first mask layer M1 is removed, a spacer layer SP may be formed to cover the upper surface of the upper semiconductor layer 13, the side surfaces of the dielectric material layers 122p, and the upper surfaces of the preliminary capping layers 126p.

An etching process using a spacer layer SP as an etching mask may be performed to form gate trenches T2 in an upper semiconductor layer 13. The gate trenches T2 may extend in the Y-direction and may be spaced apart from each other in the X-direction. The insulating layer 12 may not be exposed by the gate trenches T2. A portion of the spacer layer SP may be etched by the etching process, and the spacer layer SP may remain on a side surface of the dielectric material layers 122p. In an example embodiment, a portion of the dielectric material layers 122p and the preliminary capping layers 126p may be removed. In an example embodiment, the lower ends of the gate trenches T2 may be located at the same level as the lower ends of the back gate trenches T1 illustrated in FIG. 12, but the invention is not limited thereto. In an example embodiment, the lower ends of the gate trenches T2 may be located at a different level from the lower ends of the back gate trenches T1.

After the gate trenches T2 are formed, a second sacrificial layer SL2 may be formed. The second sacrificial layer SL2 may extend along the inner wall of the gate trenches T2 and may cover the spacer layer SP, the dielectric material layer 122p, and the preliminary capping layer 126p. The second sacrificial layer SL2 may include silicon oxide, silicon nitride, silicon oxynitride, silicon carbonitride, a low-κ dielectric, or combinations thereof. For example, the second sacrificial layer SL2 may include silicon oxide.

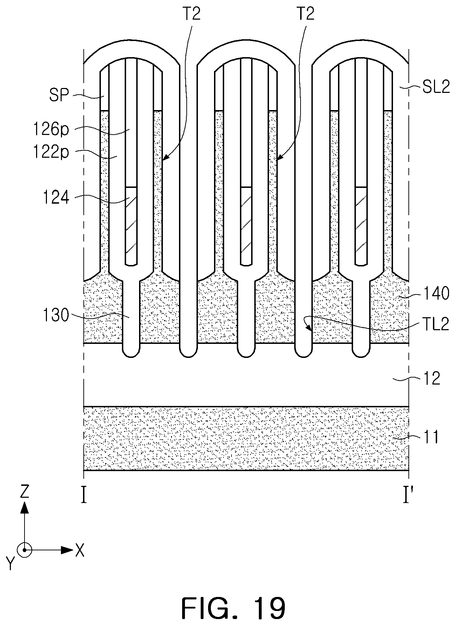

Referring to FIG. 19, an anisotropic etching process may be performed, and second lower trenches TL2 may be formed below the gate trenches T2. The second lower trenches TL2 may expose inner walls of the upper semiconductor layer 13 and an upper surface of the insulating layer 12. The lower semiconductor layer 11 may not be exposed by the first lower trenches TL1. The first lower trenches TL1 may extend in the Y-direction along the gate trenches T2 and may be spaced apart from each other in the X-direction. A horizontal width of the second lower trench TL2 in the X-direction may be smaller than a horizontal width of the back gate trench T2 in the X-direction. Although the horizontal width of the second lower trench TL2 in the X-direction is illustrated as being the same as the horizontal width of the first lower trench TL1 in the X-direction, the present inventive concept is not limited thereto. In an example embodiment, the horizontal width of the second lower trench TL2 in the X-direction may be different from the horizontal width of the first lower trench TL1 in the X-direction. For example, a horizontal average width of the second lower trench TL2 in the X-direction may be smaller than a horizontal average width of the back gate trench T2 in the X-direction. Although the horizontal average width of the second lower trench TL2 in the X-direction is illustrated as being the same as the horizontal average width of the first lower trench TL1 in the X-direction, the present inventive concept is not limited thereto. In an example embodiment, the horizontal average width of the second lower trench TL2 in the X-direction may be different from the horizontal average width of the first lower trench TL1 in the X-direction.

In an example embodiment, a portion of the second sacrificial layer SL2 covering the upper surfaces of the dielectric material layer 122p and the preliminary capping layer 126p may be removed by the anisotropic etching process.

The upper semiconductor layer 13 may be etched such that first lower trenches TL1 extend in the Y-direction by the anisotropic etching process to form an active pattern 140. The active patterns 140 may extend in the vertical direction and may be spaced apart from each other in the X-direction. Although not illustrated, the upper semiconductor layer 13 may be etched thereby separating the upper semiconductor layer 13 into a plurality of segments that are spaced apart from each other in the X-direction, before forming the back gate trenches T1 or before forming the second lower trenches TL2. Therefore, as illustrated in FIG. 1, the active patterns 140 may be spaced apart from each other in the X-direction and the Y-direction.

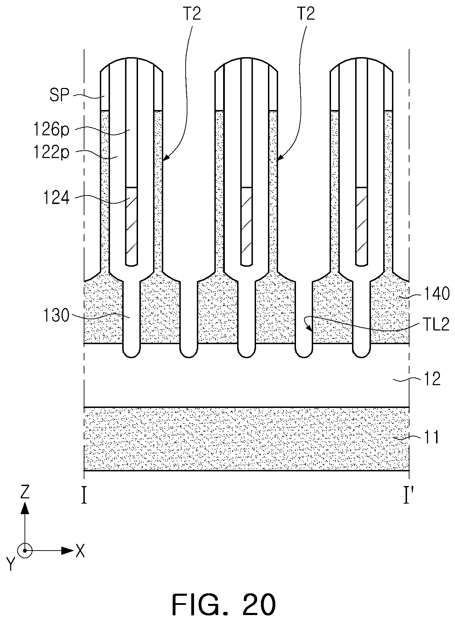

Referring to FIG. 20, the second sacrificial layer SL2 may be removed, and the inner walls of the gate trenches T2 may be exposed. In an example embodiment, the spacer layer SP, the dielectric material layer 122p, and the preliminary capping layer 126p may also be partially etched.

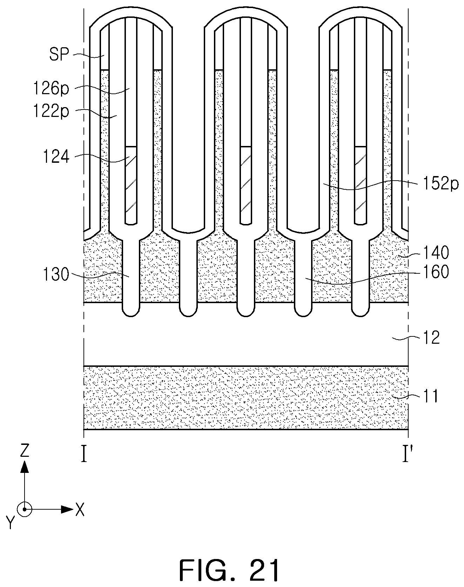

Referring to FIG. 21, the dielectric material layer 152p may be formed. For example, the dielectric material layer 152p may be deposited along the gate trenches T2 and the second lower trenches TL2 by a chemical vapor deposition method, an atomic layer deposition method, or the like. The dielectric material layer 152p may cover the spacer layer SP, the dielectric material layer 122p, and the preliminary capping layer 126p. The dielectric material layer 152p may completely fill the second lower trenches TL2, and the dielectric material layer 152p disposed within the second lower trenches TL2 may be referred to as second insulating patterns 160. The lower ends of the second insulating patterns 160 may be lower than the upper surface of the upper semiconductor layer 13 and may be in contact with the insulating layer 12.

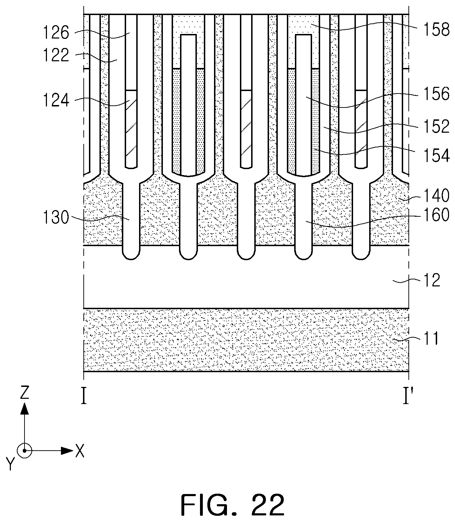

Referring to FIG. 22, word lines 154, first gate capping layers 156, and second gate capping layers 158 may be formed. The word lines 154 may be formed on the dielectric material layer 152p within the gate trenches T2. The word lines 154 may be formed by depositing a conductive material on the dielectric material layer 152p and anisotropically etching the conductive material. As illustrated in FIG. 1, the word lines 154 may extend in the Y-direction along the back gate electrodes 124 and may be spaced apart from each other in the X-direction.

The first gate capping layers 156 may be formed on the side surfaces of the word lines 154. In an example embodiment, the first gate capping layers 156 may be formed by forming an insulating material on the conductive material and anisotropically etching the insulating material together with the conductive material. When the insulating material is anisotropically etched, the spacer layer SP may be removed, and the dielectric material layer 122p and the preliminary capping layer 126p may be etched to form the back gate dielectric layer 122 and the back gate capping layer 126. The upper portion of the dielectric material layer 152p may be etched to form the gate dielectric layer 152. The back gate dielectric layer 122, the back gate electrode 124, and the back gate capping layer 126 may form the back gate structure 120 as illustrated in FIG. 2.

The second gate capping layers 158 may be formed to cover the first gate capping layers 156. The gate dielectric layer 152, the word line 154, the first gate capping layer 156, and the second gate capping layer 158 may form the word line structure 150 illustrated in FIG. 2. The upper surfaces of the active patterns 140 may be exposed, and the upper surfaces of the active patterns 140 may be coplanar with the upper surfaces of the back gate structure 120 and the word line structure 150. In some embodiments, a planarization process such as a CMP (chemical mechanical planarization) process may be performed such that the upper surfaces of the active patterns 140 may be exposed. As a result, the upper surfaces of the active patterns 140 may be coplanar with the upper surfaces of the back gate structure 120 and the word line structure 150.

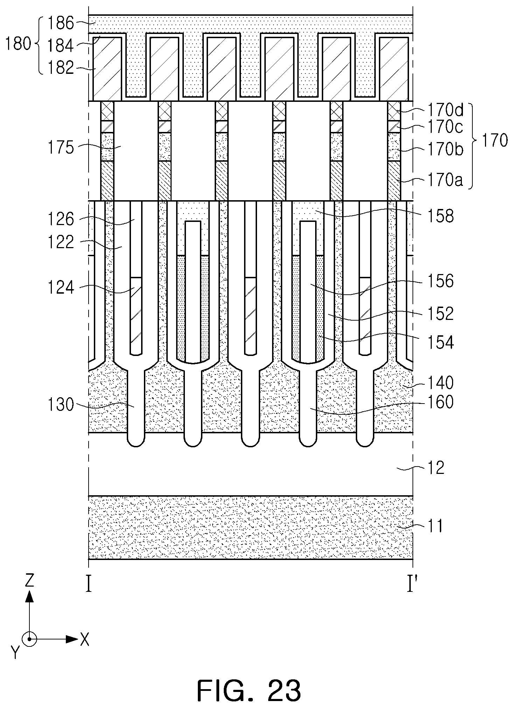

Referring to FIG. 23, a contact pattern 170, insulating patterns 175, and an information storage structure 180 may be formed on the active patterns 140. The contact pattern 170 may include a first contact pattern 170a, a second contact pattern 170b, a third contact pattern 170c, and a fourth contact pattern 170d that are sequentially stacked. The contact pattern 170 may be electrically connected to the active pattern 140.

Insulating patterns 175 may be formed between the contact patterns 170. The insulating patterns 175 may electrically insulate the contact patterns 170 from each other.

An information storage structure 180 including first electrodes 182, a dielectric layer 184, and a second electrode 186 may be formed on the contact patterns 170. The first electrodes 182 may be in contact with the fourth contact patterns 170d of the contact patterns 170.

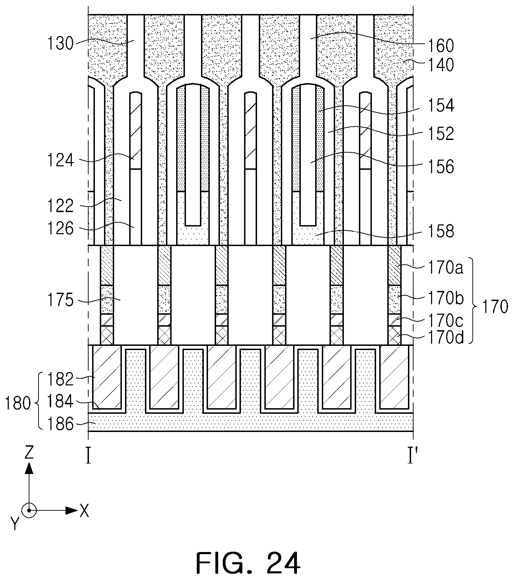

Referring to FIG. 24, the resultant structure of FIG. 23 may be flipped so that the information storage structure 180 faces downward of the lower semiconductor layer 11, and the lower semiconductor layer 11 and the insulating layer 12 may be removed. The first insulating pattern 130, the active pattern 140, and the second insulating pattern 160 may be exposed. For example, a portion of the first insulating pattern 130 may be removed such that the first insulating pattern 130 and the active pattern 140 may have surfaces which are coplanar to each other.

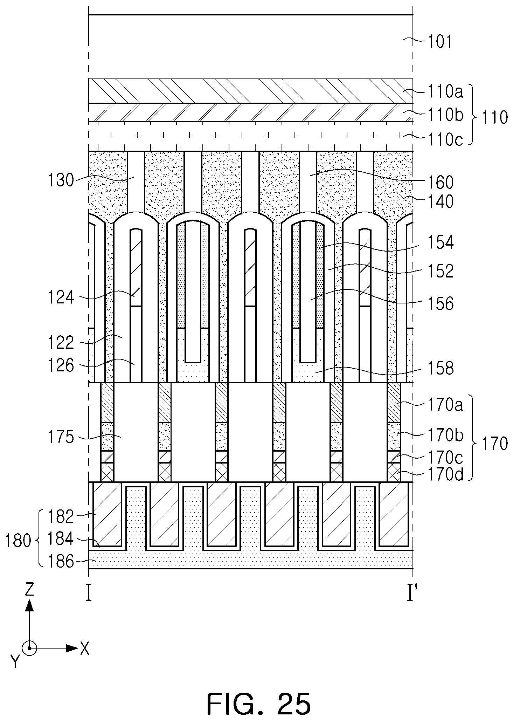

Referring to FIG. 2 and FIG. 25, a bitline structure 110 and a lower insulating layer 101 may be formed on the active patterns 140 to manufacture a semiconductor device 100. The bitline structure 110 may include a third conductive pattern 110c, a second conductive pattern 110b, and a first conductive pattern 110a sequentially stacked on the active patterns 140.

In an example embodiment, a peripheral circuit structure including peripheral circuit elements electrically connected to at least one of the bitline structures 110 may be disposed on the lower insulating layer 101. In an example embodiment, the peripheral circuit structure may be disposed on the information storage structure 180 after forming the information storage structure 180.

In an example embodiment, a cleaning process may be further performed before forming the bitline structure 110. The cleaning process may remove an oxide film formed on the active patterns 140. For example, the oxide film may be a native oxide. The first insulating pattern 130 and the second insulating pattern 160 may be partially etched by the cleaning process, and side surfaces of the active patterns 140 may be exposed. The exposed side surfaces of the active patterns 140 may be in contact with the bitline structure 110.

In a vertical channel transistor structure including an active pattern 140, a bitline structure 110, and a word line 154, if the distance between the lower surface of the word line 154 and the upper surface of the bitline structure 110 is close, there is a concern that electrical coupling may occur between the word line 154 and the bitline structure 110. When the vertical channel transistor operates, electrons may move from the bitline structure 110 to the information storage structure 180 or vice versa, but if the distance between the lower surface of the word line 154 and the upper surface of the bitline structure 110 is long, the distance that the electrons should move increases, so that current may not flow sufficiently. However, according to example embodiments, the vertical position of the word line 154 may be determined in the gate trench T2 forming process described with reference to FIG. 18 and the dielectric material layer 152p forming process described with reference to FIG. 21. Therefore, since the vertical position of the word line 154 is determined with only two processes, the dispersion of the vertical position of the word line 154 may be reduced, and the malfunction of the semiconductor device 100 may be reduced and the reliability may be improved. In addition, the vertical position of the back gate electrode 124 may be determined in the back gate trench T1 forming process described with reference to FIG. 12 and the dielectric material layer 122p forming process described with reference to FIG. 16. Therefore, since the vertical position of the back gate electrode 124 is determined with only two processes, the dispersion of the vertical position of the back gate electrode 124 may be reduced. As described above, in a memory cell, maintaining a sufficient distance between a word line and a bitline is important to suppress the electrical coupling therebetween. According to the embodiments of the invention, a memory cell may have a configuration to ensure that the distance between the lower surface of the word line 154 and the upper surface of the bitline structure 110 is sufficient. Additionally, the method of manufacturing a semiconductor device, according to the embodiments, may achieve a sufficient distance with a reduced number of process steps compared to conventional methods. While a vertical channel transistor structure is described, the disclosure is not limited thereto.

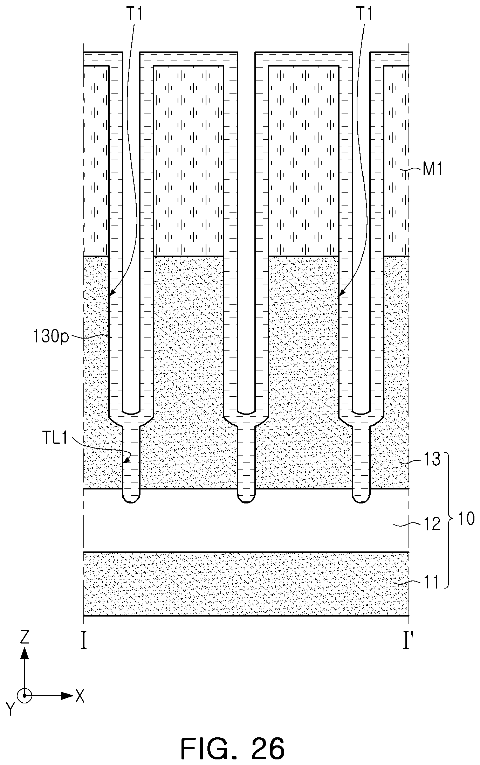

FIGS. 26 to 36 are vertical cross-sectional views illustrating process steps of a method of manufacturing a semiconductor device according to an example embodiment.

Referring to FIG. 26, the first insulating material layer 130p may be formed in the same or similar manner as the dielectric material layer 122p formation method described with reference to FIGS. 12 to 16. The first insulating material layer 130p may cover the upper surface of the first mask layer M1 and the inner walls of the back gate trenches T1. The first insulating material layer 130p may also completely fill the first lower trenches TL1.

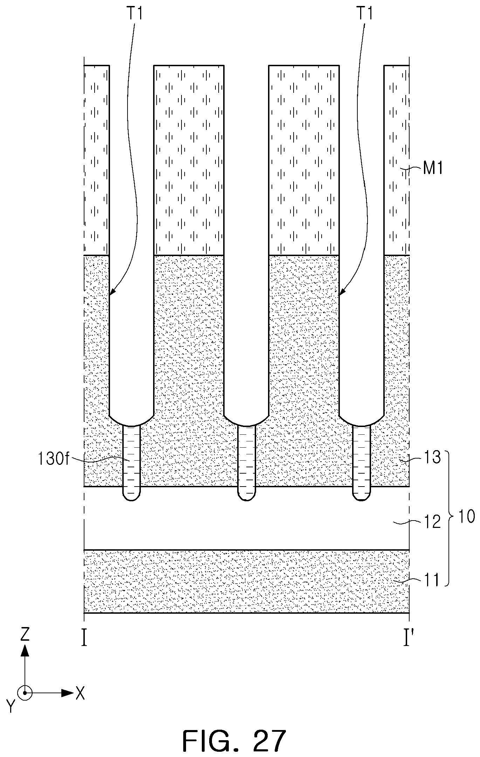

Referring to FIG. 27, the first insulating material layer 130p may be etched so that the upper surface of the first mask layer M1 and the inner walls of the back gate trenches T1 are exposed. The first insulating material layer 130p may not be completely removed, and the first insulating material layer 130p remaining in the first lower trenches TL1 may be referred to as the first insulating pattern 130f. The first insulating pattern 130f may include a structure or material identical or similar to the first insulating pattern 130f described with reference to FIG. 9.

The upper end of the first insulating pattern 130f is illustrated as being disposed at the same level as the upper end of the first lower trench TL1, but the present inventive concept is not limited thereto. In an example embodiment, the upper end of the first insulating pattern 130f may be disposed at a lower level than the upper end of the first lower trench TL1.

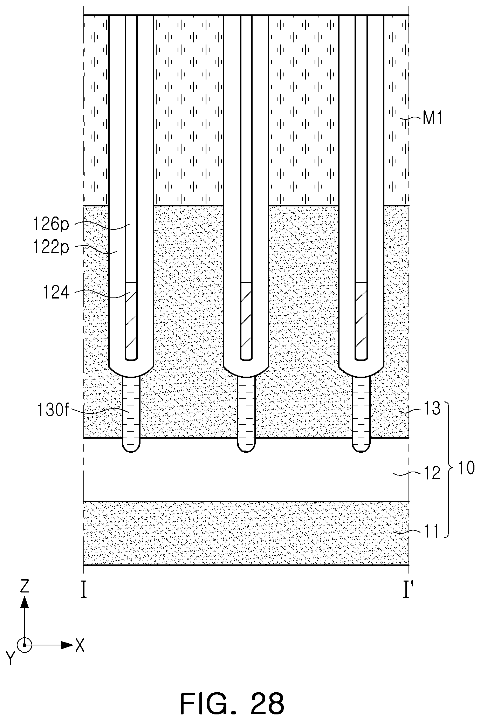

Referring to FIG. 28, dielectric material layers 122p, back gate electrodes 124, and preliminary capping layers 126p may be formed within the back gate trenches T1. The back gate electrodes 124 may fill the lower portions of the back gate trenches T1, and the preliminary capping layers 126p may be disposed on the back gate electrodes 124. The dielectric material layers 122p may include a material having an etching selectivity with the first insulating patterns 130f.

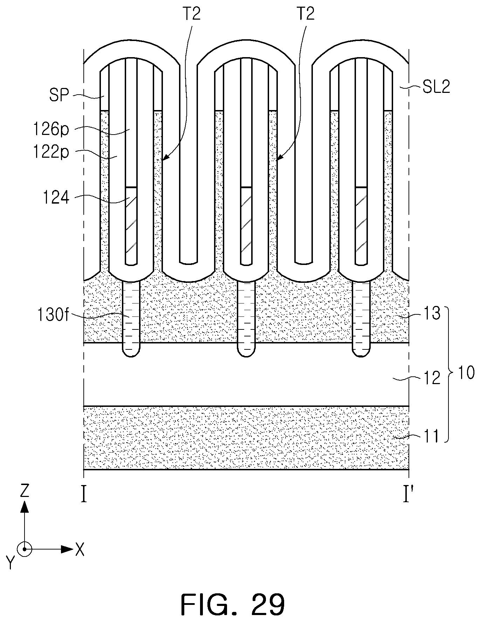

Referring to FIG. 29, a spacer layer SP may be formed on a side surface of the dielectric material layer 122p, and gate trenches T2 may be formed in the upper semiconductor layer 13. A second sacrificial layer SL2 may be formed to cover the inner wall of the gate trenches T2. The spacer layer SP, the gate trenches T2, and the second sacrificial layer SL2 may be formed in the same or similar manner as described with reference to FIG. 18.

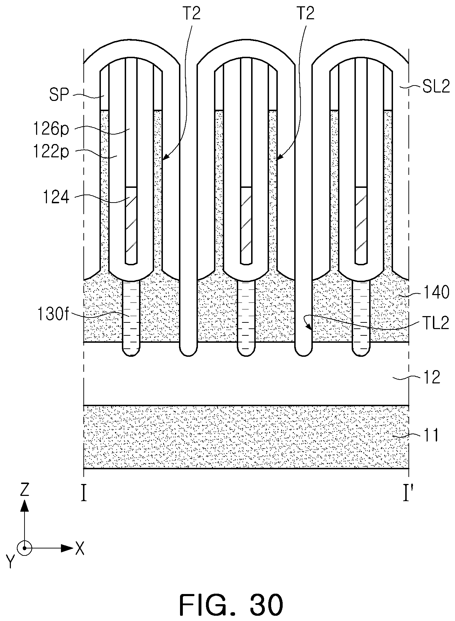

Referring to FIG. 30, an anisotropic etching process may be performed, and second lower trenches TL2 may be formed below the gate trenches T2. The second lower trenches TL2 may expose inner walls of the upper semiconductor layer 13 and an upper surface of the insulating layer 12. The lower semiconductor layer 11 may not be exposed by the second lower trenches TL2. The second lower trenches TL2 may extend in the Y-direction along the gate trenches T2 and may be spaced apart from each other in the X-direction. The horizontal width of the second lower trench TL2 in the X-direction may be smaller than the horizontal width of the back gate trench T2 in the X-direction. For example, the horizontal average width of the second lower trench TL2 in the X-direction may be smaller than the horizontal average width of the back gate trench T2 in the X-direction.

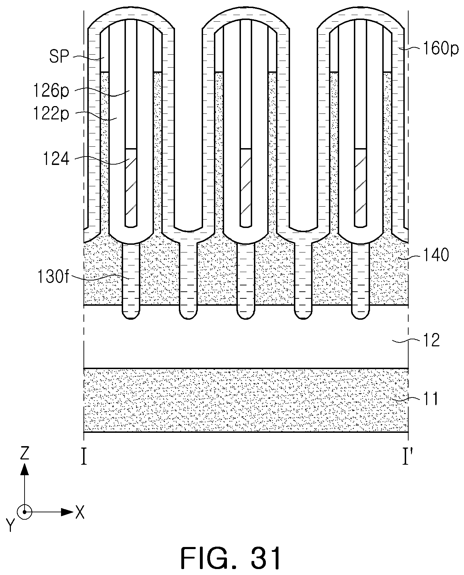

Referring to FIG. 31, the second sacrificial layer SL2 may be removed, and the second insulating material layer 160p may be formed. The second sacrificial layer SL2 may be selectively removed by a wet etching process, and the gate trenches T2 and the second lower trenches TL2 may be exposed. The second insulating material layer 160p may be formed to cover the inner wall of the gate trenches T2, and may completely fill the second lower trenches TL2.

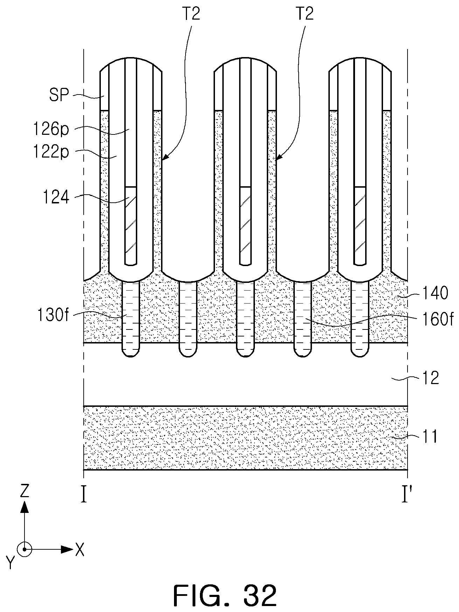

Referring to FIG. 32, the second insulating material layer 160p may be etched, and the inner wall of the gate trenches T2 may be exposed. The second insulating material layer 160p may not be completely removed, and the second insulating material layer 160p remaining within the second lower trenches TL2 may be referred to as a second insulating pattern 160f. The second insulating pattern 160f may include a structure or material identical to or similar to the second insulating pattern 160f described with reference to FIG. 9.

The upper end of the second insulating pattern 160f is illustrated as being disposed at the same level as the upper end of the second lower trench TL2, but the present inventive concept is not limited thereto. In an example embodiment, the upper end of the second insulating pattern 160f may be disposed at a lower level than the upper end of the second lower trench TL2.

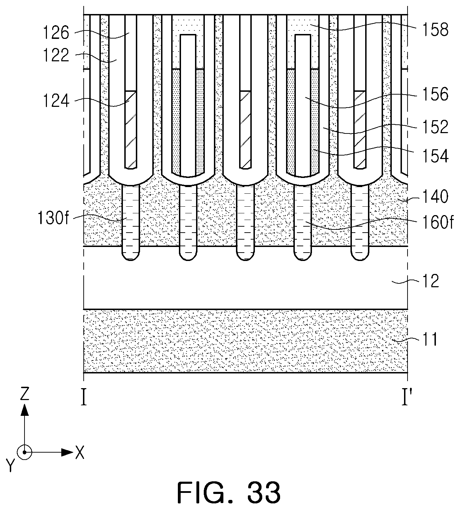

Referring to FIG. 33, the spacer layer SP may be removed, and the dielectric material layer 122p and the preliminary capping layer 126p may be etched to form a back gate dielectric layer 122 and a back gate capping layer 126. A gate dielectric layer 152, a word line 154, a first gate capping layer 156, and a second gate capping layer 158 may be formed within the gate trench T2. The gate dielectric layers 152 may include a material having an etching selectivity with the second insulating patterns 160f.

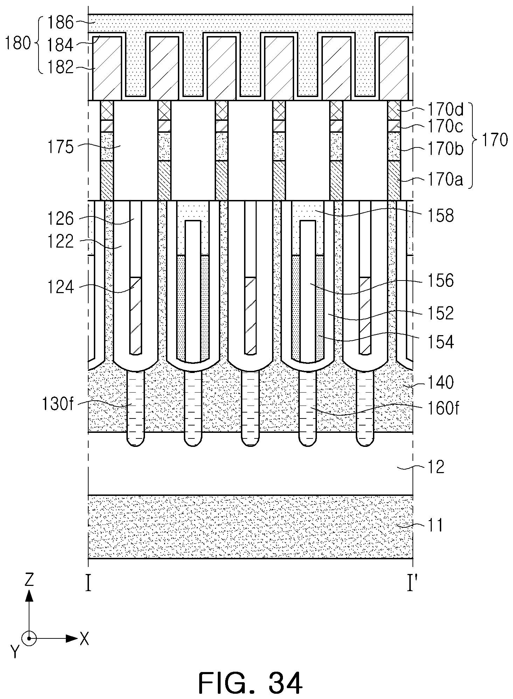

Referring to FIG. 34, a contact pattern 170, insulating patterns 175, and an information storage structure 180 may be formed on the active patterns 140.

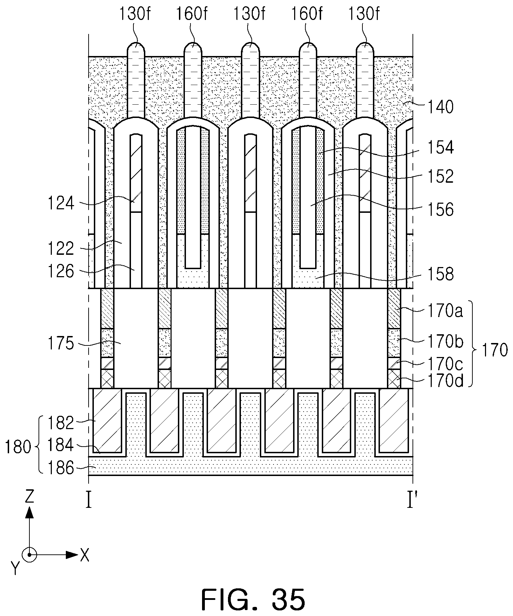

Referring to FIG. 35, the resultant structure of FIG. 23 may be flipped so that the information storage structure 180 faces downward of the lower semiconductor layer 11, and the lower semiconductor layer 11 and the insulating layer 12 may be removed. The first insulating pattern 130f, the active pattern 140, and the second insulating pattern 160f may be exposed.

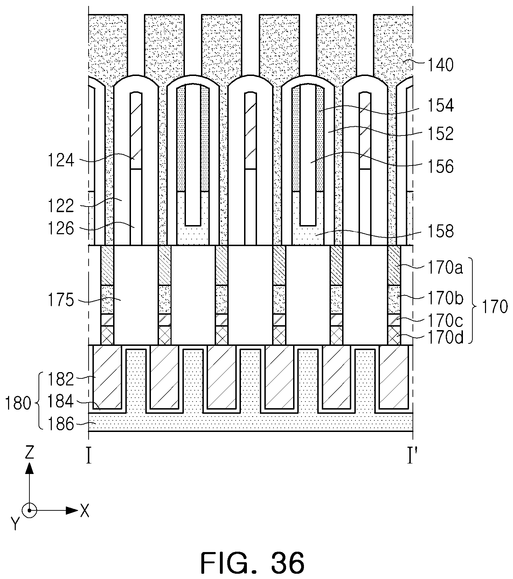

Referring to FIG. 36, the first insulating patterns 130f and the second insulating patterns 160f may be removed. The first insulating patterns 130f and the second insulating patterns 160f may include a material having an etching selectivity with respect to the active pattern 140, the back gate dielectric layer 122, and the gate dielectric layer 152. Therefore, the first insulating patterns 130f and the second insulating patterns 160f may be selectively removed by a wet etching process, and the back gate dielectric layer 122 and the gate dielectric layer 152 may be exposed.

Afterwards, an insulating material layer is formed in the space where the first insulating patterns 130f and the second insulating patterns 160f are removed, and a bitline structure 110 and a lower insulating layer 101 are formed, so that a semiconductor device corresponding to at least one of the semiconductor devices illustrated in FIGS. 3 to 11 may be manufactured.

In an example embodiment, as illustrated in FIG. 9, a bitline structure 110 may be formed on the first insulating patterns 130f and the second insulating patterns 160f without removing the first insulating patterns 130f and the second insulating patterns 160f. In an example embodiment, as illustrated in FIG. 7, first and second layers (131 and 132) and third and fourth layer (161 and 162) may be formed in the space from which the first insulating patterns 130f and the second insulating patterns 160f are removed, so that first insulating patterns 130d and second insulating patterns 160d may be formed. In an example embodiment, the first insulating patterns 130f and the second insulating patterns 160f may be removed, and the active patterns 140 may be partially etched by a wet etching process. Thereafter, as illustrated in FIG. 8, first insulating patterns 130e and second insulating patterns 160e may be formed on the active patterns 140.

As set forth above, according to example embodiments, the dispersion of a vertical-direction position of a word line may be reduced, malfunction of a semiconductor device may be reduced, and reliability may be improved. For example, as described above, the method of manufacturing a semiconductor device, according to the embodiments, may achieve the configuration to suppress the electrical coupling with a reduced number of process steps compared to conventional methods. As a result, the elements (e.g., word line) of the memory cells may undergo a reduced number of process steps, decreasing the cell-to-cell performance variation and enhancing the reliability of the semiconductor device.

While example embodiments have been illustrated and described above, it will be apparent to those skilled in the art that modifications and variations could be made, the scope of protection sought being defined by the appended claims.

## Claims

1. A semiconductor device (100) comprising:
a bitline structure (110);
a back gate structure (120) disposed on the bitline structure (110), and including a back gate electrode (124) and a back gate dielectric layer (122) covering a side surface and a lower surface of the back gate electrode (124);
a word line structure (150) disposed on the bitline structure (110) and including a word line (154) and a gate dielectric layer (152) covering a side surface and a lower surface of the word line (154);
an active pattern (140) disposed on the bitline structure (110) and extending in a vertical direction between the back gate structure (120) and the word line structure (150);
a first insulating pattern (130) contacting the active pattern (140), between the bitline structure (110) and the back gate structure (120);
a second insulating pattern (160) contacting the active pattern (140), between the bitline structure (110) and the word line structure (150); and
a contact pattern (170) on the active pattern (140),
wherein a horizontal width (Wa) of the first insulating pattern (130) is smaller than a horizontal width (Wb) of the back gate structure (120), and
wherein a horizontal width (Wc) of the second insulating pattern (160) is smaller than a horizontal width (Wd) of the word line structure (150).

2. The semiconductor device (100) of claim 1, wherein the first insulating pattern (130) is in contact with a lower end of the back gate dielectric layer (122), and/or
wherein the second insulating pattern (160) is in contact with a lower end of the gate dielectric layer (152).

3. The semiconductor device (100f) of claim 1 or 2, wherein the first insulating pattern (130f) includes the same material as a material of the back gate dielectric layer (122), and/or
wherein the second insulating pattern (160f) includes the same material as a material of the gate dielectric layer (152).

4. The semiconductor device (100) of any preceding claim, wherein the horizontal width (Wa) of the first insulating pattern (130) is smaller than the horizontal width (Wc) of the second insulating pattern (160), and/or
wherein a lower end of the back gate structure (120) is disposed at a different level from a lower end of the word line structure (150).

5. The semiconductor device (100d) of any preceding claim, wherein the first insulating pattern (130d) includes a first layer (131) contacting a side surface of the active pattern (140) and a lower end of the back gate dielectric layer (122), and a second layer (132) below the first layer (131),
wherein the first layer (131) and the second layer (132) contact an upper surface of the bitline structure (110), and
wherein the first layer (131) covers side surfaces and an upper surface of the second layer (132), and, optionally,
wherein the first layer (131) includes a different material from a material of the second layer (132).

6. The semiconductor device (100e) of any preceding claim, wherein the first insulating pattern (130e) has a convex side surface.

7. The semiconductor device (100g) of any preceding claim, wherein the back gate dielectric layer (122) includes a protrusion (122g) protruding toward the first insulating pattern (130f), and, optionally,
wherein a horizontal width of the protrusion (122g) is the same as the horizontal width (Wa) of the first insulating pattern (130f).

8. The semiconductor device (100g) of any preceding claim, wherein the gate dielectric layer (152) includes a protrusion (152g) protruding toward the second insulating pattern (160f), and, optionally,
wherein a horizontal width of the protrusion (152g) of the gate dielectric layer (152) is the same as the horizontal width (Wc) of the second insulating pattern (160f).

9. The semiconductor device (100) of any preceding claim, wherein the first insulating pattern (130) includes a material different from a material of the back gate dielectric layer (122), and/or
wherein the second insulating pattern (160) includes a material different from a material of the gate dielectric layer (152).

10. The semiconductor device (100) of any preceding claim, wherein any one of:
a distance (W2) between the first insulating pattern (130) and the second insulating pattern (160) is greater than a distance (W1) between the back gate dielectric layer (122) and the gate dielectric layer (152),
a lower end of the back gate dielectric layer (122) and a lower end of the gate dielectric layer (152) are spaced apart from an upper surface of the bitline structure (110), and
a lower surface of the first insulating pattern (130) and a lower surface of the second insulating pattern (160) are in contact with an upper surface of the bitline structure (110).

11. The semiconductor device (100h) of any preceding claim, further comprising:
an information storage pattern (180) on the contact pattern (170), and optionally,
wherein the first insulating pattern (130) vertically overlaps the back gate structure (120) and extends in the vertical direction, and/or
wherein the second insulating pattern (160) vertically overlaps the word line structure (150) and extends in the vertical direction.

12. The semiconductor device (100) of claim 1,
wherein each of the active patterns (140) includes a first portion (141) between the back gate structure (120) and the word line structure (150) and a second portion (142) disposed below the first portion (141) and in contact with the first insulating pattern (130) and the second insulating pattern (160), and
wherein a horizontal width (W2) of the second portion (142) is greater than a horizontal width (W1) of the first portion (141).

13. The semiconductor device (100) of claim 12, wherein the first portion (141) of each of the active patterns (140) includes a lower portion (141a) and an upper portion (141b) on the lower portion (141), and, optionally,
wherein a horizontal width of the lower portion (141a) decreases as it goes upward.

14. The semiconductor device (100) of claim 12, wherein at least one of:
an upper surface of the first portion (141) of each of the active patterns (140) contacts a corresponding one of the contact patterns (170),
a lower surface of the second portion (142) of each of the active patterns (140) contacts the bitline structure (110), and
the second portion (142) of each of the active patterns (140) has a concave side surface.

15. The semiconductor device (100) of claim 12, wherein the active patterns (140) include a first active pattern and a second active pattern adjacent to each other, and, optionally,
wherein a distance (Wd) between first portions (141) of the first active pattern and the second active pattern is greater than a distance (Wc) between the second portions (142) of the first active pattern and the second active pattern.

## Patentansprüche

1. Halbleitervorrichtung (100), umfassend:
eine Bitleitungsstruktur (110);
eine Rückseitengate-Struktur (120), die auf der Bitleitungsstruktur (110) angeordnet ist und eine Rückseitengate-Elektrode (124) und eine Rückseitengate-Dielektrikumschicht (122) beinhaltet, welche eine Seitenfläche und eine Grundfläche der Rückseitengate-Elektrode (124) bedeckt;
eine Wortleitungsstruktur (150), die auf der Bitleitungsstruktur (110) angeordnet ist und eine Wortleitung (154) und eine Gate-Dielektrikumschicht (152) beinhaltet, welche eine Seitenfläche und eine Grundfläche der Wortleitung (154) bedeckt;
ein aktives Muster (140), das auf der Bitleitungsstruktur (110) angeordnet ist und sich in einer vertikalen Richtung zwischen der Rückseitengate-Struktur (120) und der Wortleitungsstruktur (150) erstreckt;
ein erstes isolierendes Muster (130), das das aktive Muster (140) kontaktiert, zwischen der Bitleitungsstruktur (110) und der Rückseitengate-Struktur (120);
ein zweites isolierendes Muster (160), das das aktive Muster (140) kontaktiert, zwischen der Bitleitungsstruktur (110) und der Wortleitungsstruktur (150); und
ein Kontaktmuster (170) auf dem aktiven Muster (140),
wobei eine horizontale Breite (Wa) des ersten isolierenden Musters (130) kleiner ist als eine horizontale Breite (Wb) der Rückseitengate-Struktur (120), und
wobei eine horizontale Breite (Wc) des zweiten isolierenden Musters (160) kleiner ist als eine horizontale Breite (Wd) der Wortleitungsstruktur (150).

2. Halbleitervorrichtung (100) nach Anspruch 1, wobei das erste isolierende Muster (130) mit einem unteren Ende der Rückseitengate-Dielektrikumschicht (122) in Kontakt steht, und/oder
wobei das zweite isolierende Muster (160) mit einem unteren Ende der Gate-Dielektrikumschicht (152) in Kontakt steht.

3. Halbleitervorrichtung (100f) nach Anspruch 1 oder 2, wobei das erste isolierende Muster (130f) das gleiche Material wie ein Material der Rückseitengate-Dielektrikumschicht (122) beinhaltet, und/oder
wobei das zweite isolierende Muster (160f) das gleiche Material wie ein Material der Gate-Dielektrikumschicht (152) beinhaltet.

4. Halbleitervorrichtung (100) nach einem vorstehenden Anspruch, wobei die horizontale Breite (Wa) des ersten isolierenden Musters (130) kleiner ist als die horizontale Breite (Wc) des zweiten isolierenden Musters (160), und/oder
wobei ein unteres Ende der Rückseitengate-Struktur (120) auf einer Ebene angeordnet ist, die sich von einem unteren Ende der Wortleitungsstruktur (150) unterscheidet.

5. Halbleitervorrichtung (100d) nach einem vorstehenden Anspruch, wobei das erste isolierende Muster (130d) eine erste Schicht (131), die eine Seitenfläche des aktiven Musters (140) und ein unteres Ende der Rückseitengate-Dielektrikumschicht (122) kontaktiert, und eine zweite Schicht (132) unterhalb der ersten Schicht (131) beinhaltet,
wobei die erste Schicht (131) und die zweite Schicht (132) eine Deckfläche der Bitleitungsstruktur (110) kontaktieren, und
wobei die erste Schicht (131) Seitenflächen und eine Deckfläche der zweiten Schicht (132) bedeckt, und wahlweise
wobei die erste Schicht (131) ein Material beinhaltet, das sich von einem Material der zweiten Schicht (132) unterscheidet.

6. Halbleitervorrichtung (100e) nach einem vorstehenden Anspruch, wobei das erste isolierende Muster (130e) eine konvexe Seitenfläche aufweist.

7. Halbleitervorrichtung (100g) nach einem vorstehenden Anspruch, wobei die Rückseitengate-Dielektrikumschicht (122) einen Vorsprung (122g) beinhaltet, der zu dem ersten isolierenden Muster (130f) hin vorspringt, und wahlweise
wobei eine horizontale Breite des Vorsprungs (122g) gleich der horizontalen Breite (Wa) des ersten isolierenden Musters (130f) ist.

8. Halbleitervorrichtung (100g) nach einem vorstehenden Anspruch, wobei die Gate-Dielektrikumschicht (152) einen Vorsprung (152g) beinhaltet, der zu dem zweiten isolierenden Muster (160f) hin vorspringt, und wahlweise
wobei eine horizontale Breite des Vorsprungs (152g) der Gate-Dielektrikumschicht (152) gleich der horizontalen Breite (Wc) des zweiten isolierenden Musters (160f) ist.

9. Halbleitervorrichtung (100) nach einem vorstehenden Anspruch, wobei das erste isolierende Muster (130) ein Material beinhaltet, das sich von einem Material der Rückseitengate-Dielektrikumschicht (122) unterscheidet, und/oder
wobei das zweite isolierende Muster (160) ein Material beinhaltet, das sich von einem Material der Gate-Dielektrikumschicht (152) unterscheidet.

10. Halbleitervorrichtung (100) nach einem vorstehenden Anspruch, wobei eines der Folgenden zutrifft:
ein Abstand (W2) zwischen dem ersten isolierenden Muster (130) und dem zweiten isolierenden Muster (160) ist größer als ein Abstand (W1) zwischen der Rückseitengate-Dielektrikumschicht (122) und der Gate-Dielektrikumschicht (152),
ein unteres Ende der Rückseitengate-Dielektrikumschicht (122) und ein unteres Ende der Gate-Dielektrikumschicht (152) sind von einer Deckfläche der Bitleitungsstruktur (110) beabstandet, und
eine Grundfläche des ersten isolierenden Musters (130) und eine Grundfläche des zweiten isolierenden Musters (160) stehen mit einer Deckfläche der Bitleitungsstruktur (110) in Kontakt.

11. Halbleitervorrichtung (100h) nach einem vorstehenden Anspruch, weiter umfassend:
ein Informationsspeichermuster (180) auf dem Kontaktmuster (170), und wahlweise, wobei das erste isolierende Muster (130) die Rückseitengate-Struktur (120) vertikal überlappt und sich in der vertikalen Richtung erstreckt, und/oder
wobei das zweite isolierende Muster (160) die Wortleitungsstruktur (150) vertikal überlappt und sich in der vertikalen Richtung erstreckt.

12. Halbleitervorrichtung (100) nach Anspruch 1,
wobei jedes der aktiven Muster (140) einen ersten Abschnitt (141) zwischen der Rückseitengate-Struktur (120) und der Wortleitungsstruktur (150) und einen zweiten Abschnitt (142) beinhaltet, der unterhalb des ersten Abschnitts (141) angeordnet ist und mit dem ersten isolierenden Muster (130) und dem zweiten isolierenden Muster (160) in Kontakt steht, und
wobei eine horizontale Breite (W2) des zweiten Abschnitts (142) größer ist als eine horizontale Breite (W1) des ersten Abschnitts (141).

13. Halbleitervorrichtung (100) nach Anspruch 12, wobei der erste Abschnitt (141) jedes der aktiven Muster (140) einen unteren Abschnitt (141a) und einen oberen Abschnitt (141b) auf dem unteren Abschnitt (141) beinhaltet, und wahlweise,
wobei eine horizontale Breite des unteren Abschnitts (141a) nach oben hin abnimmt.

14. Halbleitervorrichtung (100) nach Anspruch 12, wobei mindestens eines der Folgenden zutrifft:
eine Deckfläche des ersten Abschnitts (141) jedes der aktiven Muster (140) kontaktiert ein entsprechendes der Kontaktmuster (170),
eine Grundfläche des zweiten Abschnitts (142) jedes der aktiven Muster (140) kontaktiert die Bitleitungsstruktur (110), und
der zweite Abschnitt (142) jedes der aktiven Muster (140) weist eine konkave Seitenfläche auf.

15. Halbleitervorrichtung (100) nach Anspruch 12, wobei die aktiven Muster (140) ein erstes aktives Muster und ein zweites aktives Muster beinhalten, die aneinandergrenzen, und wahlweise
wobei ein Abstand (Wd) zwischen ersten Abschnitten (141) des ersten aktiven Musters und des zweiten aktiven Musters größer ist als ein Abstand (Wc) zwischen den zweiten Abschnitten (142) des ersten aktiven Musters und des zweiten aktiven Musters.

## Revendications

1. Dispositif semi-conducteur (100) comprenant :
une structure de ligne de bits (110) ;
une structure de grille arrière (120) disposée sur la structure de ligne de bits (110), et incluant une électrode de grille arrière (124) et une couche diélectrique de grille arrière (122) couvrant une surface latérale et une surface inférieure de l'électrode de grille arrière (124) ;
une structure de ligne de mots (150) disposée sur la structure de ligne de bits (110) et incluant une ligne de mots (154) et une couche diélectrique de grille (152) couvrant une surface latérale et une surface inférieure de la ligne de mots (154) ;
un motif actif (140) disposé sur la structure de ligne de bits (110) et s'étendant dans une direction verticale entre la structure de grille arrière (120) et la structure de ligne de mots (150) ;
un premier motif isolant (130) en contact avec le motif actif (140), entre la structure de ligne de bits (110) et la structure de grille arrière (120) ;
un second motif isolant (160) en contact avec le motif actif (140), entre la structure de ligne de bits (110) et la structure de ligne de mots (150) ; et
un motif de contact (170) sur le motif actif (140),
dans lequel une largeur horizontale (Wa) du premier motif isolant (130) est inférieure à une largeur horizontale (Wb) de la structure de grille arrière (120), et
dans lequel une largeur horizontale (Wc) du second motif isolant (160) est inférieure à une largeur horizontale (Wd) de la structure de ligne de mots (150).

2. Dispositif semi-conducteur (100) selon la revendication 1, dans lequel le premier motif isolant (130) est en contact avec une extrémité inférieure de la couche diélectrique de grille arrière (122), et/ou
dans lequel le second motif isolant (160) est en contact avec une extrémité inférieure de la couche diélectrique de grille (152).

3. Dispositif semi-conducteur (100f) selon la revendication 1 ou 2, dans lequel le premier motif isolant (130f) inclut le même matériau qu'un matériau de la couche diélectrique de grille arrière (122), et/ou
dans lequel le second motif isolant (160f) inclut le même matériau qu'un matériau de la couche diélectrique de grille (152).

4. Dispositif semi-conducteur (100) selon une quelconque revendication précédente, dans lequel la largeur horizontale (Wa) du premier motif isolant (130) est inférieure à la largeur horizontale (Wc) du second motif isolant (160), et/ou
dans lequel une extrémité inférieure de la structure de grille arrière (120) est disposée à un niveau différent d'une extrémité inférieure de la structure de ligne de mots (150).

5. Dispositif semi-conducteur (100d) selon une quelconque revendication précédente, dans lequel le premier motif isolant (130d) inclut une première couche (131) en contact avec une surface latérale du motif actif (140) et une extrémité inférieure de la couche diélectrique de grille arrière (122), et une seconde couche (132) sous la première couche (131),
dans lequel la première couche (131) et la seconde couche (132) sont en contact avec une surface supérieure de la structure de ligne de bits (110), et
dans lequel la première couche (131) couvre des surfaces latérales et une surface supérieure de la seconde couche (132), et, facultativement,
dans lequel la première couche (131) inclut un matériau différent d'un matériau de la seconde couche (132).

6. Dispositif semi-conducteur (100e) selon une quelconque revendication précédente, dans lequel le premier motif isolant (130e) présente une surface latérale convexe.

7. Dispositif semi-conducteur (100g) selon une quelconque revendication précédente, dans lequel la couche diélectrique de grille arrière (122) inclut une protubérance (122g) faisant saillie vers le premier motif isolant (130f), et, facultativement,
dans lequel la largeur horizontale de la protubérance (122g) est la même que la largeur horizontale (Wa) du premier motif isolant (130f).

8. Dispositif semi-conducteur (100g) selon une quelconque revendication précédente, dans lequel la couche diélectrique de grille (152) inclut une protubérance (152g) faisant saillie vers le second motif isolant (160f), et, facultativement,
dans lequel une largeur horizontale de la protubérance (152g) de la couche diélectrique de grille (152) est la même que la largeur horizontale (Wc) du second motif isolant (160f).

9. Dispositif semi-conducteur (100) selon une quelconque revendication précédente, dans lequel le premier motif isolant (130) inclut un matériau différent d'un matériau de la couche diélectrique de grille arrière (122), et/ou
dans lequel le second motif isolant (160) inclut un matériau différent d'un matériau de la couche diélectrique de grille (152).

10. Dispositif semi-conducteur (100) selon une quelconque revendication précédente, dans lequel une quelconque parmi :
une distance (W2) entre le premier motif isolant (130) et le second motif isolant (160) est supérieure à une distance (W1) entre la couche diélectrique de grille arrière (122) et la couche diélectrique de grille (152),
une extrémité inférieure de la couche diélectrique de grille arrière (122) et une extrémité inférieure de la couche diélectrique de grille (152) sont espacées d'une surface supérieure de la structure de ligne de bits (110), et
une surface inférieure du premier motif isolant (130) et une surface inférieure du second motif isolant (160) sont en contact avec une surface supérieure de la structure de ligne de bits (110).

11. Dispositif semi-conducteur (100h) selon une quelconque revendication précédente, comprenant en outre :
un motif de stockage d'informations (180) sur le motif de contact (170), et facultativement, dans lequel le premier motif isolant (130) chevauche verticalement la structure de grille arrière (120) et s'étend dans la direction verticale, et/ou
dans lequel le second motif isolant (160) chevauche verticalement la structure de ligne de mots (150) et s'étend dans la direction verticale.

12. Dispositif semi-conducteur (100) selon la revendication 1,
dans lequel chacun des motifs actifs (140) inclut une première portion (141) entre la structure de grille arrière (120) et la structure de ligne de mots (150), et une seconde portion (142) disposée sous la première portion (141) et en contact avec le premier motif isolant (130) et le second motif isolant (160), et
dans lequel une largeur horizontale (W2) de la seconde portion (142) est supérieure à une largeur horizontale (W1) de la première portion (141).

13. Dispositif semi-conducteur (100) selon la revendication 12, dans lequel la première portion (141) de chacun des motifs actifs (140) inclut une portion inférieure (141a) et une portion supérieure (141b) sur la portion inférieure (141), et, facultativement,
dans lequel une largeur horizontale de la portion inférieure (141a) diminue à mesure qu'elle monte.

14. Dispositif semi-conducteur (100) selon la revendication 12, dans lequel au moins une parmi :
une surface supérieure de la première portion (141) de chacun des motifs actifs (140) entre en contact avec un motif correspondant parmi les motifs de contact (170),
une surface inférieure de la seconde portion (142) de chacun des motifs actifs (140) entre en contact avec la structure de ligne de bits (110), et
la seconde portion (142) de chacun des motifs actifs (140) présente une surface latérale concave.

15. Dispositif semi-conducteur (100) selon la revendication 12, dans lequel les motifs actifs (140) incluent un premier motif actif et un second motif actif adjacents l'un à l'autre, et, facultativement,
dans lequel une distance (Wd) entre de premières portions (141) du premier motif actif et du second motif actif est supérieure à une distance (Wc) entre les secondes portions (142) du premier motif actif et du second motif actif.
